(19) Europäisches Patentamt
European Patent Office
Office européen des brevets

(11) EP 1 698 460 A1

(12) # EUROPEAN PATENT APPLICATION

published in accordance with Art. 158(3) EPC

(43) Date of publication:
**06.09.2006 Bulletin 2006/36**

(21) Application number: **04808039.4**

(22) Date of filing: **22.12.2004**

(51) Int Cl.:
***B32B 27/34*** *(2006.01)* ***C09J 7/02*** *(2006.01)*
***H01L 21/304*** *(2006.01)*

(86) International application number:
**PCT/JP2004/019688**

(87) International publication number:
**WO 2005/061227 (07.07.2005 Gazette 2005/27)**

(84) Designated Contracting States:
**DE FR GB IT NL**

(30) Priority: **24.12.2003 JP 2003426456**
**09.02.2004 JP 2004031707**
**24.06.2004 JP 2004186168**

(71) Applicant: **TEIJIN LIMITED**
**Osaka-shi,**
**Osaka 541-0054 (JP)**

(72) Inventors:
- **ISHIWATA, Toyoaki**
**Iwakuni-shi,**
**Yamaguchi 740-0014 (JP)**
- **SAWAKI, Toru**
**Iwakuni-shi,**
**Yamaguchi 740-0014 (JP)**
- **YOSHITOMI, Takashi**
**Iwakuni-shi,**
**Yamaguchi 740-0014 (JP)**
- **NAKAMURA, Tsutomu**
**Iwakuni-shi,**
**Yamaguchi 740-0014 (JP)**

(74) Representative: **Hallybone, Huw George et al**
**Carpmaels and Ransford,**
**43-45 Bloomsbury Square**
**London WC1A 2RA (GB)**

(54) **MULTILAYER BODY**

(57) A laminate which is advantageously used as an insulating layer for electronic package application and as an adhesive film for fixing a semiconductor wafer for semiconductor device application, laminates comprising the same and a process for manufacturing the above laminate.

The laminate (I) comprises a base layer (A) and an adhesive layer (B) formed on one side or both sides of the layer A, the layer A is a film made of (A-1) a specific wholly aromatic polyimide ($PI^{A-1}$) or (A-2) a specific wholly aromatic polyamide ($PA^{A-2}$) and the layer B comprises (B-1) a specific wholly aromatic polyimide ($PI^{B-1}$), (B-2) a specific wholly aromatic polyamide ($PA^{B-2}$), or (B-3) a specific resin composition ($RC^{B-3}$) comprising a wholly aromatic polyimide ($PI^{B-3}$) and a specific wholly aromatic polyamide ($PA^{B-3}$), laminates comprising the same and a process for manufacturing the above laminate.



Printed by Jouve, 75001 PARIS (FR)

## Description

TECHNICAL FIELD

The present invention relates to a laminate having excellent adhesion and heat resistance. More specifically, it relates to a laminate comprising a base layer made of a wholly aromatic polyimide or a wholly aromatic polyamide and an adhesive layer formed on the base layer. The present invention relates to a process for manufacturing a laminate such as a semiconductor substrate comprising the above laminate as an adhesive sheet.

BACKGROUND ART

Along with a recent trend toward advanced functions, high performance and small size in electronic devices, electronic parts used in these electronic devices are desired to be smaller in size and lighter in weight. Therefore, semiconductor device packages, wiring materials and wiring parts having higher density, more advanced functions and higher performance are now in demand as well. Materials having excellent heat resistance, electric reliability and adhesion which can be used as high-density package materials for semiconductor packages, COL packages, LOC packages and MCM (Multi-Chip Module) and as printed wiring board materials for multi-layer FPC's are desired.

Particularly for the multi-layer FPC's which are now widely used in small-sized electronic devices such as portable telephones, attention is being paid to thin film materials having adhesion such as polyimide-based and aromatic polyamide-based materials from the market as substitutes for conventional epoxy-impregnated prepregs (refer to "Recent Trend II of Rapidly Advancing Polyimides" (published by Sumibe Techno Research Co., Ltd.) and "The Basis and Application of the Latest Polyimides" (published by NTS Co., Ltd.)). The thin film materials include a blend of a soluble thermoplastic polyimide and an epoxy resin and a siloxane-modified polyimide (JP-A 2000-109645 and JP-A 2003-292778).

Since thinner films are now desired to meet a strong demand for small-sized electronic parts, high stiffness is required due to a reduction in thickness. Further, lead-free solder is used for electronic package application in consideration of environment, and the reflow temperature is becoming higher, whereby demand for films having heat resistance and dimensional stability is growing.

Adhesive materials used in the semiconductor device manufacturing process are desired to be improved as semiconductor devices are becoming smaller in size and thickness.

The process for manufacturing semiconductor devices such as silicon and gallium arsenide semiconductor devices includes a pre-step for forming devices on a large-diameter semiconductor wafer and a post-step for dividing the wafer into chips to obtain final products.

In the pre-step, to reduce the size and thickness of each semiconductor chip, devices are formed on the large-diameter semiconductor wafer, and back-grinding is carried out to grind the rear surface of the semiconductor wafer to reduce the thickness of each chip. To grind the rear surface of the semiconductor wafer, the front surface of the semiconductor wafer must be bonded and fixed to a support.

As means of bonding the front surface of the semiconductor wafer to the support, there is proposed a method in which wax is coated on a dummy wafer (support) under heating to join the front surface of the semiconductor wafer to the support. However, after the thickness of the semiconductor wafer is reduced, the semiconductor wafer must be subjected to some treatment such as metal deposition or baking while it is bonded and fixed to the support. The method using wax has a problem with the heat resistance of wax. That is, the metal deposition and baking of the semiconductor wafer cannot be carried out while it is bonded to the support by wax.

Then, an adhesive sheet having a heat resistance of 400°C or higher is desired.

In the post-step, the semiconductor wafer is cut and divided into chips (dicing), followed by the step of die bonding the chips to lead frames. During this, the semiconductor wafer is diced, rinsed and dried while it is bonded to the adhesive sheet, followed by the step of expanding the adhesive sheet and the step of picking up the chips from the adhesive sheet.

From the dicing step to the drying step, the adhesive sheet must retain sufficiently high adhesive force for the chips. At the time of picking up the chips, the adhesive sheet must have high releasability to such an extent that the adhesive component does not adhere to the chips.

To meet these requirements, various adhesive sheets are proposed. For example, a heat sticky adhesive tape comprising a base layer and a heat sticky adhesive layer made of a composition comprising a (meth)acrylate copolymer, epoxy resin, photopolymerization low-molecular weight compound, thermally active latent epoxy resin curing agent and photopolymerization initiator is proposed (JP-A 2-32181).

A dicing film comprising a support film having a surface substantially free from a release layer and a conductive adhesive is proposed (JP-B 3-34853).

As means of separating a semiconductor substrate from a supporting substrate, there is proposed a method

using water (for example, JP-A 2001-77304, JP-A 2002-237515, JP-A 2002-203821 and JP-A 2002-192394). A method for separating a semiconductor substrate making use of volume expansion with water after expandable particles are adhered to the mating surface is proposed (for example, JP-A 2002-270553). However, these methods are not practical because separation takes a long time, thereby reducing productivity. When a heat treatment at 350°C or higher is required, the mating surface is reinforced and cannot be separated.

As means of separation when a heat treatment at 350° C or higher is carried out, there are proposed a method making use of liquid expansion by adding liquid-expandable inorganic particles such as synthetic smectite fine particles to an adhesive layer and a method for separation by expanding or dissolving an organic protective layer in a solvent (for example, JP-A 2002-270553 and JP-A 2002-343751). However, as it is possible that the expandable inorganic substance and the soluble/expandable organic protective layer may be contaminated by a metal component or a thermally decomposed product of a semiconductor product, an effective method capable of separating the semiconductor substrate in a short period of time by using an adhesive material having higher heat resistance has been desired.

As a battery container, there is proposed a film which has heat resistance, corrosion resistance and insulating properties and can be firmly bonded to a metal (JP-A 2003-340960 and JP-A 2002-56823). However, the further improvement of heat resistance is desired.

A thin film material which has stable adhesion to various materials including metals as well as excellent heat resistance, chemical stability and stiffness is desired from various fields such as aviation, auto parts and foods from the viewpoints of heat resistance, reductions in size and weight, and chemical stability.

DISCLOSURE OF THE INVENTION

It is a first object of the present invention to provide a laminate (I) having excellent heat resistance, stiffness and adhesion to another material.

It is a second object of the present invention to provide a laminate (II) which includes an adherend layer (C) firmly bonded to the surface of the adhesive layer (B) of the laminate (I) and has excellent heat resistance and stiffness.

It is a third object of the present invention to provide a laminate (III) which includes an organic protective layer (D) and layer (E) to be treated on the surface of the base layer (A) of the laminate (II).

It is a fourth object of the present invention to provide a process for manufacturing a laminate (V) comprising the organic protective layer (D) and layer (E') to be treated by treating the layer (E) to be treated of the laminate (III).

Means for Solving the Problems

The present invention is a laminate (I) comprising a base layer (A) and an adhesive layer B formed on one side or both sides of the layer A, wherein
the layer A is a film made of (A-1) a wholly aromatic polyimide ($PI^{A-1}$) having a glass transition point of 350°C or higher, or (A-2) a wholly aromatic polyamide ($PA^{A-2}$) having a glass transition point of 350°C or higher; and
the layer B comprises (B-1) a wholly aromatic polyimide ($PI^{B-1}$) having a glass transition point of 180°C or higher and lower than 350°C, (B-2) a wholly aromatic polyamide ($PA^{B-2}$) having a glass transition point of 180°C or higher and lower than 350°C, or (B-3) a resin composition ($RC^{B-3}$) comprising a wholly aromatic polyimide ($PI^{B-3}$) and a wholly aromatic polyamide ($PA^{B-3}$) having a glass transition point of 180°C or higher and lower than 350°C.

The present invention is a laminate (II) comprising the layer A, the layer B formed on one side of the layer A and an adherend layer (C) formed on the layer B.

The present invention is a laminate (III) comprising the base layer (A), the adhesive layer (B), the adherend layer (C), an organic protective layer (D) and layer (E) to be treated, wherein the layer B and the layer C are formed on one side of the layer A in the mentioned order, and the layer D and the layer E are formed on the other side of the layer A in the mentioned order.

Further, the present invention is a process for manufacturing a laminate (V) comprising the layer D and the layer E (E') to be treated from the laminate (III), comprising the steps of:

(1) treating the exterior surface of the layer E of the laminate (III) to obtain a laminate (III') comprising a layer E';
(2) maintaining the laminate (III') at 350° C or higher;
(3) separating the layer C from the laminate (III') to obtain a laminate (IV) comprising the layer B, the layer A, the layer D and the layer E'; and
(4) disassembling the laminate (IV) at the interface between the layer A and the layer D to obtain the laminate (V) comprising the layer (D) and the layer (E').

In this text, the base layer (A) may be referred to as "layer A", the adhesive layer (B) to "layer B" , the adherend layer (C) to "layer C", the organic protective layer (D) to "layer D", the layer (E) to be treated to "layer E" and the layer

E (E') to be treated to "layer E'".

Effect of the Invention

The laminate (I) of the present invention has excellent heat resistance, stiffness, dimensional stability and adhesion to another material. Therefore, it can be advantageously used as an adhesive sheet in various fields such as electronic materials including package materials, members for use in the semiconductor manufacturing process, battery containers, aviation parts, auto parts and foods. Particularly in the field of electronic materials, it can be advantageously used as an insulating material having excellent dimensional stability. The laminate (I) can be made thinner than conventionally used insulating materials and has high handling ease as it has excellent stiffness.
The laminate (II) of the present invention is excellent in heat resistance, dimensional stability and adhesion to the adherend layer (C). Therefore, even when a material having low thermal expansion coefficient such as silicon or 42 alloy is used as the adherend layer (C), the peeling of the adherend layer (C) does not occur.
The laminate (III) of the present invention is excellent in heat resistance, dimensional stability and adhesion and can be used as an intermediate material in the semiconductor manufacturing process.
According to the process for manufacturing the laminate (V) of the present invention, since the laminate (I) comprising a specific adhesive layer (B) is used as an adhesive sheet, the adherend layer (C) can be easily separated from the adhesive layer (B) by a heat treatment. Also the organic protective layer (D) can be easily separated from the base layer (A). Therefore, according to the process of the present invention, a thinned semiconductor part which is subjected to a heat treatment at a high temperature of 350° C or higher can be efficiently manufactured without being contaminated by a thermally decomposed product.

BEST MODE FOR CARRYING OUT THE INVENTION

The present invention will be described in detail hereinunder.

<laminate (I)>

The laminate (I) of the present invention comprises a base layer (A) and an adhesive layer (B) which is formed on one side or both sides of the base layer (A).
The layer A is a film made of (A-1) a wholly aromatic polyimide ($PI^{A-1}$) having a glass transition temperature of 350° C or higher or (A-2) a wholly aromatic polyamide ($PA^{A-2}$) having a glass transition temperature of 350°C or higher.
The layer B comprises (B-1) a wholly aromatic polyimide ($PI^{B-1}$) having a glass transition point of 180°C or higher and lower than 350°C, (B-2) a wholly aromatic polyamide ($PB^{B-2}$) having a glass transition point of 180°C or higher and lower than 350°C, or (B-3) a resin composition ($RC^{B-3}$) comprising a wholly aromatic polyimide ($PI^{B-3}$) and a wholly aromatic polyamide ($PA^{B-3}$) having a glass transition point of 180°C or higher and lower than 350°C.
Preferably, the laminate (I) of the present invention has two crossing directions with a Young's modulus of more than 3 GPa in the plane. The laminate (I) may become unsatisfactory in terms of stiffness at a Young's modulus of 3GPa or less and may deteriorate in treatment step durability in various applications. This tendency becomes more marked as the laminate becomes thinner. Young's moduli in two crossing directions in the plane are preferably 5 GPa or more, more preferably 7 GPa or more.
The shape of the laminate (I) may be tape-like, label-like or any other shapes. The laminate (I) can have any one of the following structures:

(1) a structure that the layer A comprises $PI^{A-1}$ and the layer B comprises $PI^{B-1}$,
(2) a structure that the layer A comprises $PI^{A-1}$ and the layer B comprises $PA^{B-2}$,
(3) a structure that the layer A comprises $PI^{A-1}$ and the layer B comprises a resin composition ($RC^{B-3}$) comprising $PI^{B-3}$ and $PA^{B-3}$,
(4) a structure that the layer A comprises $PA^{A-2}$ and the layer B comprises $PI^{B-1}$,
(5) a structure that the layer A comprises $PA^{A-2}$ and the layer B comprises $PA^{B-2}$, and
(6) a structure that the layer A comprises $PA^{A-2}$ and the layer B comprises a resin composition ($RC^{B-3}$) comprising $PI^{B-3}$ and $PA^{B-3}$.

<Layer A>

The layer A is a film made of (A-1) a wholly aromatic polyimide ($PI^{A-1}$) having a glass transition point of 350° C or higher or (A-2) a wholly aromatic polyamide ($PA^{A-2}$) having a glass transition point of 350° C or higher.
When the glass transition point is lower than 350° C, heat resistance and dimensional stability become unsatisfactory. A trouble occurs in a heat treatment in the semiconductor manufacturing process or the solder reflow step for package application. The glass transition point is preferably 355° C or higher, more preferably 355 to 600° C. The glass transition point is computed from a dynamic loss tangent tan δ calculated from a dynamic storage elastic modulus E' and a dynamic loss elastic modulus E' ' obtained by the measurement of dynamic viscoelasticity.

The layer A is preferably a film having two crossing directions with a Young's modulus of more than 10 GPa in the plane. When the Young's modulus is 10 GPa or less, satisfactory stiffness may not be obtained and handling ease may deteriorate. This tendency becomes particularly marked when the thickness of the layer A becomes 25 μm or less. The Young's moduli in the two crossing directions are preferably 12 GPa or more, particularly preferably 14 GPa or more.

Preferably, the layer A has a linear thermal expansion coefficient of -12 ppm/°C to 12 ppm/°C. The linear thermal expansion coefficient of the layer A is more preferably -10 ppm/°C to 10 ppm/°C. When the linear thermal coefficient is within the above range, the resulting laminate can be advantageously used as an insulating material having excellent dimensional stability for electronic material application.

Preferably, the layer A has an average thickness of 50 μm or less. When the thickness of the layer A is larger than 50 μm, the thickness of the whole laminate increases as the base layer becomes thicker, whereby size and thickness requirements in various applications may not be satisfied. From the above requirements, the thickness of the layer A is more preferably 30 μm or less, much more preferably 20 μm or less, particularly preferably 15 μm or less. The lower limit is not particularly limited but substantially about 0.1 μm from the viewpoint of the handling ease of the film.

<wholly aromatic polyimide ($PI^{A-1}$)>

The wholly aromatic polyimide ($PI^{A-1}$) having a glass transition point of 350°C or higher (A-1) constituting the layer A is a wholly aromatic polyimide having constituent units derived from an aromatic tetracarboxylic acid component and an aromatic diamine component.

Examples of the aromatic tetracarboxylic acid component include pyromellitic acid, 1,2,3,4-benzenetetracarboxylic acid, 2,3,5,6-pyridinetetracarboxylic acid, 2,3,4,5-thiophenetetracarboxylic acid, 2,2',3,3'-benzophenonetetracarboxylic acid, 2,3',3,4'-benzophenonetetracarboxylic acid, 3,3',4,4'-benzophenonetetracarboxylic acid, 3,3',4,4'-biphenyltetracarboxylic acid, 2,2',3,3'-biphenyltetracarboxylic acid, 2,3,3',4'-biphenyltetracarboxylic acid, 3,3',4,4'-p-terphenyltetracarboxylic acid, 2,2',3,3'-p-terphenyltetracarboxylic acid, 2,3,3',4'-p-terphenyltetracarboxylic acid, 1,2,4,5-naphthalenetetracarboxylic acid, 1,2,5,6-naphthalenetetracarboxylic acid, 1,2,6,7-naphthalenetetracarboxylic acid, 1,4,5,8-naphthalenetetracarboxylic acid, 2,3,6,7-naphthalenetetracarboxylic acid, 2,3,6,7-anthracenetetracarboxylic acid, 1,2,5,6-anthracenetetracarboxylic acid, 1,2,6,7-phenanthrenetetracarboxylic acid, 1,2,7,8-phenanthrenetetracarboxylic acid, 1,2,9,10-phenanthrenetetracarboxylic acid, 3,4,9,10-perylenetetracarboxylic acid, 2,6-dichloronaphthalene-1,4,5,8-tetracarboxylic acid, 2,7-dichloronaphthalene-1,4,5,8-tetracarboxylic acid, 2,3,6,7-tetrachloronaphthalene-1,4,5,8-tetracarboxylic acid, 1,4,5,8-tetrachloronaphthalene-2,3,6,7-tetracarboxylic acid, bis(2,3-dicarboxyphenyl)ether, bis(3,4-dicarboxyphenyl)ether, bis(2,3-dicarboxyphenyl)methane, bis(3,4-dicarboxyphenyl)methane, bis(2,3-dicarboxyphenyl)sulfone, bis(3,4-dicarboxyphenyl)sulfone, 1,1-bis(2,3-dicarboxyphenyl)ethane, 1,1-bis(3,4-dicarboxyphenyl) ethane, 2,2-bis(2,3-dicarboxyphenyl)propane, 2,2-bis(3,4-dicarboxyphenyl)propane, 2,6-bis(3,4-dicarboxyphenoxy)pyridine, 1,1,1,3,3,3-hexaflouro-2,2-bis(3,4-dicarboxyphenyl) propane and bis(3,4-dicarboxyphenyl)dimethylsilane. These aromatic tetracarboxylic acid components may be used in combination of two or more.

Out of these, pyromellitic acid alone or a combination of pyromellitic acid and the above aromatic tetracarboxylic acid other than pyromellitic acid is preferred as the aromatic tetracarboxylic acid component.

More specifically, pyromellitic dianhydride is preferably contained in an amount of 50 to 100 mol% of the total of all the tetracarboxylic acid components. When the amount of pyromellitic dianhydride is 50 mol% or more, the concentration of the imido group in the wholly aromatic polyimide can be increased, thereby making it possible to improve adhesion. The amount of pyromellitic dianhydride is preferably 70 to 100 mol%, more preferably 90 to 100 mol%. Particularly preferably, pyromellitic dianhydride is used alone.

Examples of the aromatic diamine component include 1,4-phenylenediamine, 1,3-phenylenediamine, 1,4-diaminonaphthalene, 1,5-diaminonaphthalene, 1,8-diaminonaphthalene, 2,6-diaminonaphthalene, 2,7-diaminonaphthalene, 2,6-diaminoanthracene, 2,7-diaminoanthracene, 1,8-diaminoanthracene, 2,4-diaminotoluene, 2,5-diamino(m-xylene), 2,5-diaminopyridine, 2,6-diaminopyridine, 3,5-diaminopyridine, 2,4-diaminotoluenebenzidine, 3,3'-diaminobiphenyl, 3,3'-dichlorobenzidine, 3,3'-dimethylbenzidine, 3,3'-dimethoxybenzidine, 2,2'-diaminobenzophenone, 4,4'-diaminobenzophenone, 3,3'-diaminodiphenyl ether, 4,4'-diaminodiphenyl ether, 3,4'-diaminodiphenyl ether, 3,3'-diaminodiphenylmethane, 4,4'-diaminodiphenylmethane, 3,4'-diaminodiphenylmethane, 3,4'-diaminodiphenylsulfone, 4,4'-diaminodiphenylsulfone, 3,3'-diaminodiphenyl sulfide, 3,4'-diaminodiphenyl sulfide, 4,4'-diaminodiphenyl sulfide, 4,4'-diaminodiphenyl thioether, 4,4'-diamino-3,3'5,5'-tetramethyldiphenyl ether, 4,4'-diamino-3,3',5,5'-tetraethyldiphenyl ether, 4,4'-diamino-3,3',5,5'-tetramethyldiphenylmethane, 1,3-bis(3-aminophenoxy)benzene, 1,3-bis(4-aminophenoxy)benzene, 1,4-bis(3-aminophenoxy)benzene, 1,4-bis(4-aminophenoxy)benzene, 2,6-bis(3-aminophenoxy)pyridine, 1,4-bis (3-aminophenylsulfonyl)benzene, 1,4-bis(4-aminophenylsulfonyl)benzene, 1,4-bis(3-aminophenylthioether)benzene,

1,4-bis(4-aminophenylthioether)benzene, 4,4'-bis(3-aminophenoxy)diphenylsulfone, 4,4'-bis(4-aminophenoxy)diphenylsulfone, bis(4-aminophenyl)amine, bis(4-aminophenyl)-N-methylamine, bis(4-aminophenyl)-N-phenylamine, bis(4-aminophenyl)phosphine oxide, 1,1-bis(3-aminophenyl)ethane, 1,1-bis(4-aminophenyl)ethane, 2,2-bis(3-aminophenyl) propane, 2,2-bis(4-aminophenyl)propane, 2,2-bis(4-amino-3,5-dimethylphenyl)propane, 4,4'-bis(4-aminophenoxy)biphenyl, bis[4-(3-aminophenoxy)phenyl]sulfone, bis[4-(4-aminophenoxy)phenyl]sulfone, bis[4-(4-aminophenoxy)phenyl] ether, bis[4-(4-aminophenoxy)phenyl]methane, bis[3-methyl-4-(4-aminophenoxy)phenyl]methane, bis[3-chloro-4-(4-aminophenoxy)phenyl]methane, bis[3,5-dimethyl-4-(4-aminophenoxy)phenyl]methane, 1,1-bis[4-(4-aminophenoxy) phenyl]ethane, 1,1-bis[3-methyl-4-(4-aminophenoxy)phenyl]ethane, 1,1-bis[3-chloro-4-(4-aminophenoxy)phenyl] ethane, 1,1-bis[3,5-dimethyl-4-(4-aminophenoxy)phenyl]ethane, 2,2-bis [4-(4-aminophenoxy)phenyl]propane, 2,2-bis [3-methyl-4-(4-aminophenoxy)phenyl]propane, 2,2-bis[3-chloro-4-(4-aminophenoxy)phenyl]propane, 2,2-bis[3,5-dimethyl-4-(4-aminophenoxy)phenyl]propane, 2,2-bis[4-(4-aminophenoxy)phenyl]butane, 2,2-bis[3-methyl-4-(4-aminophenoxy)phenyl]butane, 2,2-bis[3,5-dimethyl-4-(4-aminophenoxy)phenyl]butane, 2,2-bis[3,5-dibromo-4-(4-aminophenoxy) phenyl]butane, 1,1,1,3,3,3-hexafluoro-2,2-bis(4-aminophenyl)propane, 1,1,1,3,3,3-hexafluoro-2,2-bis[3-methyl-4-(4-aminophenoxy)phenyl]propane and components obtained by substituting the aromatic nucleus thereof by a halogen atom or alkyl group. The above aromatic diamine components may be used in combination of two or more.

1,4-phenylenediamine, 1,3-phenylenediamine, 3,4'-diaminodiphenyl ether, 1,3-bis(3-aminophenoxy)benzene and 4,4'-diaminodiphenyl ether are preferred as the aromatic diamine component. 1,4-phenylenediamine is preferably contained in an amount of 40 to 100 mol% of the total of all the aromatic diamine components. 1,3-phenylenediamine, 3,4'-diaminodiphenyl ether, 4,4'-diaminodiphenyl ether and 1,3-bis(3-aminophenoxy)benzene are preferred as aromatic diamine components other than 1,4-phenylenediamine. Out of these, 3,4'-diaminodiphenyl ether is particularly preferred.

Therefore, a wholly aromatic polyimide comprising a constituent unit represented by the following formula (I) is preferred as the wholly aromatic polyimide ($PI^{A-1}$).

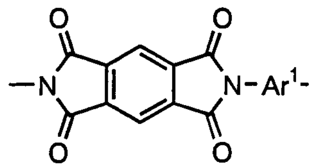

· · · (I)

In the above formula (I), $Ar^1$ is a 1,4-phenylene group which may contain a non-reactive substituent.

Examples of the non-reactive substituent include alkyl groups such as methyl group, ethyl group, propyl group and cyclohexyl group, aromatic groups such as phenyl group and naphthyl group, halogen groups such as chloro group, fluoro group and bromo group, alkoxy groups such as methoxy group, ethoxy group and phenoxy group, and nitro group.

Therefore, examples of the group represented by $Ar^1$ include 2-chloro-1,4-phenylene group, 2-bromo-1,4-phenylene group, 2-methyl-1,4-phenylene group, 2-ethyl-1,4-phenylene group, 2-cyclohexyl-1,4-phenylene group, 2-phenyl-1,4-phenylene group, 2-nitro-1,4-phenylene group, 2-methoxy-1,4-phenylene group,
2,5-dichloro-1,4-phenylene group,
2,6-dichloro-1,4-phenylene group,
2,5-dibromo-1,4-phenylene group,
2,6-dibromo-1,4-phenylene group,
2-chloro-5-bromo-1,4-phenylene group,
2-chloro-5-fluoro-1,4-phenylene group,
2,5-dimethyl-1,4-phenylene group,
2,6-dimethyl-1,4-phenylene group,
2,5-dicyclohexyl-1,4-phenylene group,
2,5-diphenyl-1,4-phenylene group,
2,5-dinitro-1,4-phenylene group,
2,5-dimethoxy-1,4-phenylene group,
2,3,5-trichloro-1,4-phenylene group,
2,3,5-trifluoro-1,4-phenylene group,
2,3,5-trimethyl-1,4-phenylene group,
2,3,5,6-tetrachloro-1,4-phenylene group,
2,3,5,6-tetrafluoro-1,4-phenylene group,
2,3,5,6-tetrabromo-1,4-phenylene group,
2,3,5,6-tetramethyl-1,4-phenylene group and
2,3,5,6-tetraethyl-1,4-phenylene group. Out of these,

1,4-phenylene group is particularly preferred.

A wholly aromatic polyimide comprising 40 mol% or more and less than 100 mol% of the constituent unit represented by the above formula (I) and more than 0 mol% and 60 mol% or less of a constituent unit represented by the following formula (IV) is preferred as the wholly aromatic polyimide ($PI^{A-1}$).

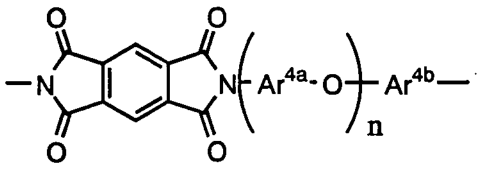

· · · (IV)

In the above formula (IV), $Ar^{4a}$ and $Ar^{4b}$ are each independently an aromatic group having 6 to 20 carbon atoms which may contain a non-reactive substituent.

Examples of the non-reactive substituent are the same as those listed for the non-reactive substituent in $Ar^1$ in the above formula (I). Examples of the aromatic group having 6 to 20 carbon atoms include phenylene group and naphthalenediyl group.

Examples of the groups represented by $Ar^{4a}$ and $Ar^{4b}$ include 1,4-phenylene group, 2-chloro-1,4-phenylene group, 2-bromo-1,4-phenylene group, 2-methyl-1,4-phenylene group, 2-ethyl-1,4-phenylene group, 2-cyclohexyl-1,4-phenylene group, 2-phenyl-1,4-phenylene group, 2-nitro-1,4-phenylene group, 2-methoxy-1,4-phenylene group, 2,5-dichloro-1,4-phenylene group, 2,6-dichloro-1,4-phenylene group, 2,5-dibromo-1,4-phenylene group, 2,6-dibromo-1,4-phenylene group, 2-chloro-5-bromo-1,4-phenylene group, 2-chloro-5-fluoro-1,4-phenylene group, 2,5-dimethyl-1,4-phenylene group, 2,6-dimethyl-1,4-phenylene group, 2,5-dicyclohexyl-1,4-phenylene group, 2,5-diphenyl-1,4-phenylene group, 2,5-dinitro-1,4-phenylene group, 2,5-dimethoxy-1,4-phenylene group, 2,3,5-trichloro-1,4-phenylene group, 2,3,5-trifluoro-1,4-phenylene group, 2,3,5-trimethyl-1,4-phenylene group, 2,3,5,6-tetrachloro-1,4-phenylene group, 2,3,5,6-tetrafluoro-1,4-phenylene group, 2,3,5,6-tetrabromo-1,4-phenylene group, 2,3,5,6-tetramethyl-1,4-phenylene group, 2,3,5,6-tetraethyl-1,4-phenylene group, 1,3-phenylene group, 5-chloro-1,3-phenylene group, 5-bromo-1,3-phenylene group, 5-methyl-1,3-phenylene group, 5-ethyl-1,3-phenylene group, 5-cyclohexyl-1,3-phenylene group, 5-phenyl-1,3-phenylene group, 5-nitro-1,3-phenylene group, 5-methoxy-1,3-phenylene group, 2,5-dichloro-1,3-phenylene group, 2,5-dibromo-1,3-phenylene group, 2,5-dibromo-1,3-phenylene group, 2-chloro-5-bromo-1,3-phenylene group, 2-chloro-5-fluoro-1,3-phenylene group, 2,5-dimethyl-1,3-phenylene group, 2,5-dimethyl-1,3-phenylene group, 2,5-dicyclohexyl-1,3-phenylene group, 2,5-diphenyl-1,3-phenylene group, 2,5-dinitro-1,3-phenylene group, 2,5-dimethoxy-1,3-phenylene group, 2,4,6-trichloro-1,3-phenylene group, 2,4,6-trifluoro-1,3-phenylene group, 2,4,6-trimethyl-1,3-phenylene group, 1,6-biphenylene group and 2,6-naphthylene group. Out of these, 1,4-phenylene group and 1,3-phenylene group are preferred.

In the above formula (IV), n is 1 or 2. When n is 2, substantially two $Ar^{4a}$'s are existent in the formula (VI). The two $Ar^{4a}$'s may be independently different or the same in structure. Particularly preferably, n is 1.

<manufacture of wholly aromatic polyimide film>

A film of the wholly aromatic polyimide ($PI^{A-1}$) can be manufactured by the following method. That is, an aromatic tetracarboxylic acid component and an aromatic diamine component as raw materials are polymerized in an organic polar solvent to produce a solution containing a polyamic acid or a polyamic acid derivative as a precursor. Thereafter, the solution is cast over a support, dried and heated to be imidized so as to produce the above film.

The aromatic tetracarboxylic acid component as a raw material is, for example, an aromatic tetracarboxylic dianhydride. Part or all of the aromatic tetracarboxylic acid component may be a dicarboxylic acid halide or an alkyl dicarboxylate derivative. An aromatic tetracarboxylic dianhydride is preferably used.

The aromatic diamine component as a raw material is, for example, an aromatic diamine or an amic acid forming derivative of an aromatic diamine. One or all of the amino groups of the aromatic diamine component may be trialkylsilylated. Or, one or all of the amino groups may be amidated by an aliphatic acid such as acetic acid. Out of these, an aromatic diamine is preferably used.

Examples of the organic polar solvent include N-methyl-2-pyrrolidone, dimethyl acetamide and dimethyl imidazolidinone. The polymerization temperature is preferably -30 to 120°C. Drying is preferably carried at 80 to 400°C. The heat treatment is preferably carried out at 250 to 600°C.

The above film is also manufactured by chemically carrying out a cyclodehydration reaction between an aliphatic anhydride such as dicyclohexyl carbodiimide or acetic anhydride and an organic nitrogen compound such as pyridine to obtain a swollen gel film, stretching the gel film and drying and heating the film under fixed length (JP-A 2002-179810).

It can be said that this method which enables the control of linear thermal expansion coefficient and Young's moduli by stretching conditions is particularly preferred for this application.

<wholly aromatic polyamide ($PA^{A-2}$)>

The wholly aromatic polyamide ($PA^{A-2}$) having a glass transition point of 350°C or higher (A-2) constituting the layer A is a wholly aromatic polyamide having constituent units derived from an aromatic dicarboxylic acid component and an aromatic diamine component.

Examples of the aromatic dicarboxylic acid component include terephthalic acid, isophthalic acid, 1,4-dicarboxynaphthalene, 1,5-dicarboxynaphthalene, 1,8-dicarboxynaphthalene, 2,6-dicarboxynaphthalene, 2,7-dicarboxynaphthalene, 2,6-dicarboxyanthracene, 2,7-dicarboxyanthracene, 1,8-dicarboxyanthracene, 2,4-dicarboxytoluene, 2,5-dicarboxy(m-xylene), 3,3'-dicarboxybiphenyl, 2,2'-dicarboxybenzophenone, 4,4'-dicarboxybenzophenone, 3,3'-dicarboxydiphenyl ether, 4,4'-dicarboxydiphenyl ether, 3,4'-dicarboxydiphenyl ether, 3,3'-dicarboxydiphenylmethane, 4,4'-dicarboxydiphenylmethane, 3,4'-dicarboxydiphenylmethane, 3,4'-dicarboxydiphenylsulfone, 4,4'-dicarboxydiphenylsufone, 3,3'-dicarboxydiphenyl sulfide, 3,4'-dicarboxydiphenyl sulfide, 4,4'-dicarboxydiphenyl sulfide, 4,4'-dicarboxydiphenylthioether, 4,4'-dicarboxy-3,3',5,5'-tetramethyldiphenylether, 4,4'-dicarboxy-3,3' ,5,5'-tetraethyldiphenylether, 4,4'-dicarboxy-3,3',5,5'-tetramethyldiphenylmethane, 1,3-bis(3-carboxyphenoxy)benzene, 1,3-bis(4-carboxyphenoxy)benzene, 1,4-bis(3-carboxyphenoxy)benzene, 1,4-bis(4-carboxyphenoxy)benzene, 2,6-bis(3-carboxyphenoxy)pyridine, 1,4-bis (3-carboxyphenylsulfonyl)benzene, 1,4-bis(4-carboxyphenylsulfonyl)benzene, 1,4-bis(3-carboxyphenylthioether)benzene, 1,4-bis(4-carboxyphenylthioether)benzene, 4,4'-bis(3-carboxyphenoxy)diphenylsulfone, 4,4'-bis(4-carboxyphenoxy)diphenylsulfone, bis(4-carboxyphenyl)amine, bis(4-carboxyphenyl)-N-methylamine, bis(4-carboxyphenyl)-N-phenylamine, bis(4-carboxyphenyl)phosphine oxide, 1,1-bis(3-carboxyphenyl)ethane, 1,1-bis(4-carboxyphenyl)ethane, 2,2-bis(3-carboxyphenyl)propane, 2,2-bis(4-carboxyphenyl)propane, 2,2-bis(4-carboxy-3,5-dimethylphenyl)propane, 4,4'-bis(4-carboxyphenoxy)biphenyl, bis[4-(3-carboxyphenoxy)phenyl]sulfone, bis[4-(4-carboxyphenoxy)phenyl]sulfone, bis [4-(4-carboxyphenoxy)phenyl]ether, bis[4-(4-carboxyphenoxy)phenyl]methane, bis[3-methyl-4-(4-carboxyphenoxy) phenyl]methane, bis[3-chloro-4-(4-carboxyphenoxy)phenyl]methane, bis[3,5-dimethyl-4-(4-carboxyphenoxy)phenyl] methane, 1,1-bis[4-(4-carboxyphenoxy)phenyl]ethane, 1,1-bis[3-methyl-4-(4-carboxyphenoxy)phenyl]ethane, 1,1-bis [3-chloro-4-(4-carboxyphenoxy)phenyl]ethane, 1,1-bis[3,5-dimethyl-4-(4-carboxyphenoxy)phenyl]ethane, 2,2-bis[4-(4-carboxyphenoxy)phenyl]propane, 2,2-bis[3-methyl-4-(4-carboxyphenoxy)phenyl]propane, 2,2-bis[3-chloro-4-(4-carboxyphenoxy)phenyl]propane, 2,2-bis[3,5-dimethyl-4-(4-carboxyphenoxy)phenyl]propane, 2,2-bis[4-(4-carboxyphenoxy)phenyl]butane, 2,2-bis[3-methyl-4-(4-carboxyphenoxy)phenyl]butane, 2,2-bis[3,5-dimethyl-4-(4-carboxyphenoxy) phenyl]butane, 2,2-bis[3,5-dibromo-4-(4-carboxyphenoxy)phenyl]butane, 1,1,1,3,3,3-hexafluoro-2,2-bis(4-carboxyphenyl)propane, 1,1,1,3,3,3-hexafluoro-2,2-bis[3-methyl-4-(4-carboxyphenoxy)phenyl]propane and components obtained by substituting the aromatic nucleus thereof by a halogen atom or an alkyl group. The above aromatic dicarboxylic acid components may be used in combination of two or more.

Terephthalic acid and isophthalic acid are preferred as the aromatic dicarboxylic acid component. Out of these, terephthalic acid is particularly preferred from the viewpoints of mechanical properties and heat resistance.

Examples of the aromatic diamine component include 1,4-phenylenediamine, 1,3-phenylenediamine, 1,4-diaminonaphthalene, 1,5-diaminonaphthalene, 1,8-diaminonaphthalene, 2,6-diaminonaphthalene, 2,7-diaminonaphthalene, 2,6-diaminoanthracene, 2,7-diaminoanthracene, 1,8-diaminoanthracene, 2,4-diaminotoluene, 2,5-diamino(m-xylene), 2,5-diaminopyridine, 2,6-diaminopyridine, 3,5-diaminopyridine, 2,4-diamonotoluenebenzidine, 3,3'-diaminobiphenyl, 2,2'-diaminobenzophenone, 4,4'-diaminobenzophenone, 3,3'-diaminodiphenyl ether, 4,4'-diaminodiphenyl ether, 3,4'-diaminodiphenyl ether, 3,3'-diaminodiphenylmethane, 4,4'-diaminodiphenylmethane, 3,4'-diaminodiphenylmethane, 3,4'-diaminodiphenylsulfone, 4,4'-diaminodiphenylsulfone, 3,3'-diaminodiphenyl sulfide, 3,4'-diaminodiphenyl sulfide, 4,4'-diaminodiphenyl sulfide, 4,4'-diaminodiphenylthioether, 4,4'-diamino-3,3',5,5'-tetramethyldiphenyl ether, 4,4'-diamino-3,3',5,5'-tetraethyldiphenyl ether, 4,4'-diamino-3,3',5,5'-tetramethyldiphenylmethane, 1,3-bis(3-aminophenoxy)benzene, 1,3-bis(4-aminophenoxy)benzene, 1,4-bis(3-aminophenoxy)benzene, 1,4-bis(4-aminophenoxy)benzene, 2,6-bis(3-aminophenoxy)pyridine, 1,4-bis(3-aminophenylsulfonyl)benzene, 1,4-bis(4-aminophenylsulfonyl)benzene, 1,4-bis(3-aminophenylthioether)benzene, 1,4-bis(4-aminophenylthioether)benzene, 4,4'-bis(3-aminophenoxy) diphenylsulfone, 4,4'-bis(4-aminophenoxy)diphenylsulfone, bis(4-aminophenyl)amine, bis(4-aminophenyl)-N-methylamine, bis(4-aminophenyl)-N-phenylamine, bis(4-aminophenyl)phosphine oxide, 1,1-bis(3-aminophenyl)ethane, 1,1-bis (4-aminophenyl)ethane, 2,2-bis(3-aminophenyl)propane, 2,2-bis(4-aminophenyl)propane, 2,2-bis(4-amino-3,5-dimethylphenyl)propane, 4,4'-bis(4-aminophenoxy)biphenyl, bis[4-(3-aminophenoxy)phenyl]sulfone, bis[4-(4-aminophenoxy) phenyl]sulfone, bis[4-(4-aminophenoxy)phenyl]ether, bis[4-(4-aminophenoxy)phenyl]methane, bis[3-methyl-4-(4-aminophenoxy)phenyl]methane, bis[3-chloro-4-(4-aminophenoxy)phenyl]methane, bis[3,5-dimethyl-4-(4-aminophenoxy) phenyl]methane, 1,1-bis[4-(4-aminophenoxy)phenyl]ethane, 1,1-bis[3-methyl-4-(4-aminophenoxy)phenyl]ethane, 1,1-bis[3-chloro-4-(4-aminophenoxy)phenyl]ethane, 1,1-bis[3,5-dimethyl-4-(4-aminophenoxy)phenyl]ethane, 2,2-bis[4-(4-aminophenoxy)phenyl]propane, 2,2-bis[3-methyl-4-(4-aminophenoxy)phenyl]propane, 2,2-bis[3-chloro-4-(4-aminophenoxy)phenyl]propane, 2,2-bis[3,5-dimethyl-4-(4-aminophenoxy)phenyl]propane, 2,2-bis[4-(4-aminophenoxy)phenyl]butane, 2,2-bis[3-methyl-4-(4-aminophenoxy)phenyl]butane, 2,2-bis[3,5-dimethyl-4-(4-aminophenoxy)phenyl]butane, 2,2-bis[3,5-dibromo-4-(4-aminophenoxy)phenyl]butane, 1,1,1,3,3,3-hexafluoro-2,2-bis(4-aminophenyl)propane, 1,1,1,3,3,3-hexafluoro-2,2-bis[3-methyl-4-(4-aminophenoxy)phenyl]propane and components obtained by substituting the aromatic nucleus thereof by a halogen atom or alkyl group. The above aromatic diamine components may be used in combination of two or more.

1,4-phenylenediamine, 1,3-phenylenediamine, 3,4'-diaminodiphenyl ether, 4,4'-diaminodiphenyl ether and 1,3-bis(3-aminophenoxy)benzene are preferred as the aromatic diamine component. Out of these, 1,4-phenylenediamine is particularly preferred from the viewpoints of mechanical properties and heat resistance.

The wholly aromatic polyamide ($PA^{A-2}$) is preferably a wholly aromatic polyamide comprising a constituent unit represented by the following formula (V).

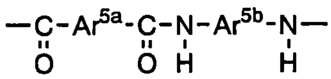

• • • (V)

In the above formula (V), $Ar^{5a}$ and $Ar^{5b}$ are each independently an aromatic group having 6 to 20 carbon atoms which may have a non-reactive substituent.

Examples of the aromatic group having 6 to 20 carbon atoms include phenylene group, naphthalenediyl group, anthracenediyl group and toluenediyl group.

Examples of the non-reactive substituent include alkyl groups such as methyl group, ethyl group, propyl group and cyclohexyl group, aromatic groups such as phenyl group and naphthyl group, halogen groups such as chloro group, fluoro group and bromo group, nitro group, methoxy group, ethoxy group and phenoxy group.

Therefore, the wholly aromatic polyamide ($PA^{A-2}$) is particularly preferably a wholly aromatic polyamide comprising a constituent unit represented by the following formula (II).

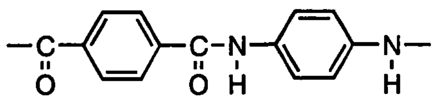

• • • (II)

<manufacture of wholly aromatic polyamide film>

The wholly aromatic polyamide ($PA^{A-2}$) can be manufactured by the following method. That is, it can be manufactured by reacting a chloride of the above aromatic dicarboxylic acid component with the above aromatic diamine component in an organic polar solvent such as N-methyl-2-pyrrolidone, N,N-dimethylacetamide or N,N-dimethylformamide.

It can also be manufactured by carrying out the interfacial polymerization of similar raw materials using an organic solvent such tetrahydrofuran and a poor solvent such as water. An alkali such as an aqueous solution of sodium hydroxide may be used as a polymerization accelerator for the interfacial polymerization.

The film can be manufactured by a wet process or dry process using the obtained wholly aromatic polyamide solution. The wholly aromatic polyamide solution after polymerization may be used as it is.

The wholly aromatic polyamide may be re-dissolved in a solvent after it is isolated before use. The solvent is preferably an organic polar solvent such as N-methyl-2-pyrrolidone, N,N-dimethylacetamide or N,N-dimethylformamide. In the case of a wholly aromatic polyamide having low solubility, a strong acid solvent such as concentrated sulfuric acid, concentrated nitric acid or polyphosphoric acid is preferably used.

An inorganic salt such as calcium chloride, magnesium chloride, lithium chloride or lithium nitrate may be optionally added to the wholly aromatic polyamide solution as a dissolving aid. The concentration of the wholly aromatic polyamide in the solution is preferably 1 to 60 wt%, more preferably 3 to 40 wt%.

The surface of the layer A constituting the laminate (I) may be subjected to a surface treatment such as corona treatment, plasma treatment or sandblast treatment, and an acid treatment with nitric acid, alkali treatment with potassium hydroxide or treatment with a surface modifier such as a silane coupling agent, in order to obtain a stable adhesion with layer B.

<adhesive layer (B)>

The adhesive layer (B) constituting the laminate (I) of the present invention is formed on one side or both sides

of the above layer A. When the layer B is to be formed on both sides of the layer A, the thicknesses and compositions of the layers B can be set independently and suitably to the following ranges according to their purposes and the adherend layer (C). Therefore, when the layer B is formed on both sides, the structure and constitution in the thickness direction of the laminate may be symmetrical or asymmetrical.

The layer B comprises (B-1) a wholly aromatic polyimide ($PI^{B-1}$) having a glass transition point of 180°C or higher and lower than 350°C, (B-2) a wholly aromatic polyamide ($PA^{B-2}$) having a glass transition point of 180°C or higher and lower than 350°C, or (B-3) a resin composition ($RC^{B-3}$) comprising a wholly aromatic polyimide ($PI^{B-3}$) and a wholly aromatic polyamide ($PA^{B-3}$) having a glass transition point of 180°C or higher and lower than 350°C.

When the layer B comprises $PI^{B-1}$ or $PA^{B-2}$, if the glass transition point is lower than 180° C, heat resistance becomes unsatisfactory and if the glass transition point is 350°C or higher, a high temperature may be required for bonding the layer B to the adherend layer (C), or adhesion may deteriorate. The glass transition point is preferably 200 to 345°C, more preferably 220 to 340°C.

The thickness of the layer B is preferably in the range of 0.1 to 50 μm. When the thickness is smaller than 0.1 μm, adhesion accuracy to the adherend layer (C) is not obtained, the accuracies of the flatness and smoothness of the contact surface of a contact bonding device are required, the control of flatness and smoothness becomes unsatisfactory, and bonding nonuniformity frequently occurs. When the thickness is larger than 50 μm, heat is hardly conducted for bonding the layer B to the adherend layer (C) made of an inorganic material, thereby taking time to transmit a temperature and reducing productivity. The whole laminate becomes thick and may not satisfy the size and thickness requirements in various applications.

Therefore, in consideration of the preferred thickness of the layer A, the thickness of the whole laminate (I) is preferably substantially 1 to 150 μm. It is more preferably 1 to 100 μm, much more preferably 1 to 50 μm, particularly preferably 2 to 25 μm.

The layer B may take any form according to the shape of the laminate, the shape of the adherend layer (C) and the use purpose and method of the laminate. Stated more specifically, the layer B itself may be formed as a fine coating film. With a view to controlling adhesive force, an inorganic salt such as glass, carbon, titanium oxide, talc, foamed particles or barium titanate, metal or glass particles, short fibers or whiskers may be added within limits that do not impair their original characteristic properties. For example, they may be added in an amount of 40 vol% or less.

The layer B may be porous to increase its adhesion accuracy or control its adhesive force. When it is porous, pores may be continuous or independent. A material having a porosity of, for example, 80 % or less may be preferably used. As an example of the method of manufacturing the porous layer B, a method of manufacturing a wholly aromatic porous polyamide disclosed, for example, by PCT/JP03/11729 can be advantageously employed.

Further, the layer B does not need to be always existent on the entire surface of the layer A and may take any form according to the shape of the laminate, the shape of the adherend layer (C) and the use purpose and method of the laminate. For example, the layer B may be existent only at the center portion of a tape-like laminate, only at both end portions or in a lattice. The layer B may also be existent on the peripheral portion or center portion of a disk-like laminate, or partially in a radial form. Not particularly limited, if the adhesive layer is existent on an area of 10 % or more of the total area of the adhesive existent surface of the layer A, it can be advantageously used in most cases.

The constituent components of the wholly aromatic polyimide ($PI^{B-1}$) and the wholly aromatic polyamide ($PA^{B-2}$) used in the layer B may be the same as those used for the base layer (A). From the viewpoint of adhesion, the requirement for glass transition point must be satisfied as described above. A preferred wholly aromatic polyimide and a preferred wholly aromatic polyamide differ according to a combination of constituent components and composition ratio.

<wholly aromatic polyimide ($PI^{B-1}$)>

The wholly aromatic polyimide ($PI^{B-1}$) having a glass transition point of 180° C or higher and lower than 350° C (B-1) constituting the layer B is a wholly aromatic polyimide having constituent units derived from an aromatic tetracarboxylic acid component and an aromatic diamine component.

Examples of the aromatic tetracarboxylic acid component are the same as those listed for the above wholly aromatic polyimide ($PI^{A-1}$).

Pyromellitic acid alone or a combination of pyromellitic acid and the above aromatic tetracarboxylic acid different from pyromellitic acid is preferred as the aromatic tetracarboxylic acid component from the viewpoints of chemical stability and heat resistance. More specifically, pyromellitic dianhydride is contained in an amount of 50 to 100 mol% of the total of all the tetracarboxylic acid components. When the amount of pyromellitic dianhydride is 50 mol% or more, the concentration of the imido group in the wholly aromatic polyimide can be increased to improve adhesion. The amount of pyromellitic dianhydride is more preferably 70 to 100 mol%, much more preferably 90 to 100 mol%. Particularly preferably, pyromellitic dianhydride is used alone.

Examples of the aromatic diamine component are the same as those listed for the above wholly aromatic polyimide ($PI^{A-1}$).

1,4-phenylenediamine, 1,3-phenylenediamine, 3,4'-diaminodiphenyl ether, 1,3-bis(3-aminophenoxy)benzene and 4,4'-diaminodiphenyl ether are preferred as the aromatic diamine component. At least 3,4'-diaminodiphenyl ether, 1,3-bis(3-aminophenoxy)benzene and 4,4'-diaminodiphenyl ether are more preferred.

As a particularly preferred aromatic diamine component, at least one selected from the group comprising 3,4'-diaminodiphenyl ether, 1,3-bis(3-aminophenoxy)benzene and 4,4'-diaminodiphenyl ether is contained in an amount of 70 to 100 mol% of the total of all the diamine components. 1,4-phenylenediamine and 1,3-phenylenediamine are preferred as other aromatic diamine components. Out of these, a combination of 3,4'-diaminodiphenyl ether and other aromatic diamine component is preferred. 3,4'-diaminodiphenyl ether is particularly preferably used alone.

Therefore, a wholly aromatic polyimide comprising a constituent unit represented by the following formula (IV) is used as the wholly aromatic polyimide ($PI^{B-1}$).

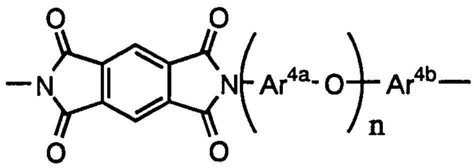

· · · (IV)

In the above formula (IV), $Ar^{4a}$ and $Ar^{4b}$ are each independently an aromatic group having 6 to 20 carbon atoms which may contain a non-reactive substituent. n is 1 or 2.

Examples of the aromatic group having n to 20 carbon atoms include phenylene group and naphthalenediyl group.

Examples of the non-reactive substituent include alkyl groups such as methyl group, ethyl group, propyl group and cyclohexyl group, aromatic groups such as phenyl group and naphthyl group, halogen groups such as chloro group, fluoro group and bromo group, alkoxyl groups such as methoxy group, ethoxy group and phenoxy group, and nitro group.

A wholly aromatic polyimide comprising 70 mol% or more and less than 100 mol% of the constituent unit represented by the above formula (IV) and more than 0 mol% and 30 mol% or less of a constituent unit represented by the following formula (I) is used.

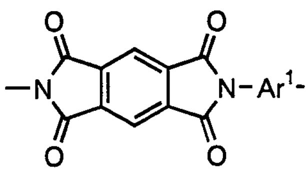

· · · (I)

In the formula (I), $Ar^1$ is a 1,4-phenylene group which may contain a non-reactive substituent. Examples of the non-reactive substituent include alkyl groups such as methyl group, ethyl group, propyl group and cyclohexyl group, aromatic groups such as phenyl group and naphthyl group, halogen groups such as chloro group, fluoro group and bromo group, alkoxyl groups such as methoxy group, ethoxy group and phenoxy group, and nitro group.

<formation of layer B made of wholly aromatic polyimide ($PI^{B-1}$)>

The layer B can be formed by casting an organic polar solvent solution of a polyamic acid or a polyamic acid derivative as a wholly aromatic polyimide precursor over the layer A and drying it. The solution may be heated to be thermally imidized while it is dried. Two or more polyamic acids or polyamic acid derivatives are used to form a layer made of a compatible blend of two or more polyimides.

A dehydrating agent such as acetic anhydride or an organic base catalyst such as pyridine may be added to the solution as a suitable imidizing aid.

Preferred examples of the polar organic solvent include N-methyl-2-pyrrolidone, N,N-dimethylacetamide and N,N-dimethylformamide.

Casting is carried out by extrusion from a die, with an applicator or with a coater.

The temperature of the solution when it is cast is not particularly limited and preferably selected to ensure that the viscosity of the solution becomes 30 to 20,000 poise. The viscosity is more preferably 50 to 2,000 poise.

After casting, the solvent is scattered by drying. Drying is carried out by heating with hot air, vacuum heating, infrared heating or microwave heating. Drying by heating with hot air is preferred. The drying temperature is 30 to 650°C,

preferably 40 to 600°C, more preferably 70 to 550°C.

As other means, a wholly aromatic polyimide film manufactured in the same manner as the above layer A is laminated by a hot roll or hot press.

<wholly aromatic polyamide ($PA^{B-2}$)>

The wholly aromatic polyamide ($PA^{B-2}$) having a glass transition point of 180° C or higher and lower than 350° C (B-2) constituting the layer B is a wholly aromatic polyamide derived from an aromatic dicarboxylic acid component and an aromatic diamine component.

Examples of the aromatic dicarboxylic acid component include terephthalic acid and isophthalic acid. Out of these, isophthalic acid is particularly preferred from the viewpoints of mechanical properties and heat resistance.

Examples of the aromatic diamine component include 1,4-phenylenediamine, 1,3-phenylenediamine, 3,4'-diaminodiphenyl ether, 4,4'-diaminodiphenyl ether and 1,3-bis(3-aminophenoxy)benzene. 1,3-phenylenediamine, 3,4'-diaminodiphenyl ether, 4,4'-diaminodiphenyl ether and 1,3-bis(3-aminophenoxy)benzene are preferred from the viewpoints of mechanical properties and heat resistance. Out of these, 1,3-phenylenediamine and 3,4'-diaminodiphenyl ether are particularly preferred.

Therefore, a wholly aromatic polyamide derived from an aromatic dicarboxylic acid which is terephthalic acid and/or isophthalic acid and at least one aromatic diamine component selected from the group comprising 1,4-phenylenediamine, 1,3-phenylenediamine, 3,4'-diaminodiphenyl ether, 4,4'-diaminodiphenyl ether and 1,3-bis(3-aminophenoxy) benzene is particularly preferred as the wholly aromatic polyamide ($PA^{B-2}$).

More specifically, a wholly aromatic polyamide comprising a constituent unit represented by the following formula (V) is used.

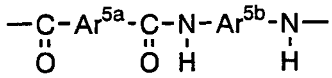
· · · (V)

In the formula (V), $Ar^{5a}$ and $Ar^{5b}$ are each independently an aromatic group having 6 to 20 carbon atoms which may contain a non-reactive substituent.

Examples of the aromatic group having 6 to 20 carbon atoms include phenylene group, naphthalenediyl group, anthracenediyl group and toluenediyl group.

Examples of the non-reactive substituent include alkyl groups such as methyl group, ethyl group, propyl group and cyclohexyl group, aromatic groups such as phenyl group and naphthyl group, halogen groups such as chloro group, fluoro group and bromo group, nitro group, methoxy group, ethoxy group and phenoxy group.

A wholly aromatic polyamide represented by the following formula (III) is preferred as the wholly aromatic polyamide.

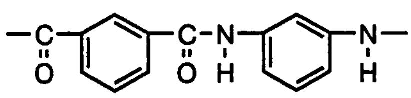
· · · (III)

A wholly aromatic polyamide represented by the following formula (VI) is also preferred.

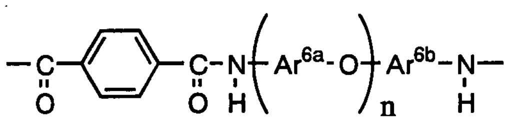
· · · (VI)

In the above formula (VI), $Ar^{6a}$ and $Ar^{6b}$ are each independently an aromatic group having 6 to 20 carbon atoms which may contain a non-reactive substituent.

Examples of the aromatic group having 6 to 20 carbon atoms include phenylene group, naphthalenediyl group, anthracenediyl group and toluenediyl group. Phenylene group is preferred, and 1,4-phenylene group and 1,3-phenylene group are particularly preferred.

Examples of the non-reactive substituent include alkyl groups such as methyl group, ethyl group, propyl group

and cyclohexyl group, aromatic groups such as phenyl group and naphthyl group, halogen groups such as chloro group, fluoro group and bromo group, alkoxyl groups such as methoxy group, ethoxy group and phenoxy group, and nitro group.

n is 1 or 2. When n is 2, two $Ar^{6a}$'s are substantially existent in the formula (VI) and may be different or the same in structure. Particularly preferably, n is 1.

A wholly aromatic polyamide comprising a recurring unit represented by the formula (III) and a recurring unit represented by the formula (VI) is also used. Preferably, the amount of the recurring unit represented by the formula (III) is 10 to 90 mol% and the amount of the recurring unit represented by the formula (VI) is 90 to 10 mol% of the total of all the recurring units.

<formation of layer B made of wholly aromatic polyamide>

The wholly aromatic polyamide ($PA^{B-2}$) can be manufactured by the following method. That is, it can be manufactured by reacting a chloride of the above aromatic dicarboxylic acid component with the above aromatic diamine component in an organic polar solvent such as N-methyl-2-pyrrolidone, N,N-dimethylacetamide or N,N-dimethylformamide.

It can also be manufactured by carrying out the interfacial polymerization of the above raw materials using an organic solvent such as tetrahydrofuran and a poor solvent such as water. An alkali such as an aqueous solution of sodium hydroxide may be used as a polymerization accelerator for the interfacial polymerization.

The layer B can be formed by casting the obtained wholly aromatic polyamide solution over the layer A and drying it. The wholly aromatic polyamide solution after polymerization may be used as it is.

The wholly aromatic polyamide may be re-dissolved in a solvent after it is isolated before use. The solvent is preferably an organic polar solvent such as N-methyl-2-pyrrolidone, N,N-dimethylacetamide or N,N-dimethylformamide. In the case of the wholly aromatic polyamide having low solubility, a strong acid solvent such as concentrated sulfuric acid, concentrated nitric acid or polyphosphoric acid is preferably used.

An inorganic salt such as calcium chloride, magnesium chloride, lithium chloride or lithium nitrate may be optionally added as a dissolving aid to the wholly aromatic polyamide solution. The concentration of the wholly aromatic polyamide in the solution is preferably 1 to 60 wt%, more preferably 3 to 40 wt%.

Casting is carried out by extrusion from a die, with an applicator or with a coater.

The temperature of the solution when it is cast is not particularly limited and preferably selected to ensure that the viscosity of the solution becomes 30 to 20,000 poise. The viscosity is more preferably 50 to 2,000 poise.

After casting, the solvent is scattered by drying. Drying is carried out by heating with hot air, vacuum heating, infrared heating or microwave heating. Drying by heating with hot air is preferred. The drying temperature is 30 to 500°C, preferably 40 to 450°C, more preferably 70 to 400°C.

As other means, the wholly aromatic polyamide film manufactured in the same manner as the above layer A is laminated by a hot roll or hot press.

<resin composition ($RC^{B-3}$)>

The layer B may be made of a resin composition ($RC^{B-3}$) comprising a wholly aromatic polyimide ($PI^{B-3}$) and a wholly aromatic polyamide ($PA^{B-3}$) having a glass transition point of 180° C or higher and lower than 350° C.

When the glass transition point of the wholly aromatic polyamide ($PA^{B-3}$) is lower than 180° C, heat resistance becomes unsatisfactory. When the glass transition point is 350°C or higher, a high temperature and a high pressure may be required for adhesion between the layer B and the adherend layer (C), or adhesion may deteriorate. The glass transition point of the wholly aromatic polyamide ($PA^{B-3}$) is preferably 200 to 345°C, more preferably 220 to 340°C.

Use of a resin composition comprising the above combination makes it possible to select a layer B having both heat resistance and adhesion which are more and more required nowadays in the fields of semiconductors and electronic materials as well as desired adhesion and heat resistance for various types of adherends.

Preferably, the resin composition ($RC^{B-3}$) comprises 10 to 99 wt% of the wholly aromatic polyimide ($PI^{B-3}$) and 1 to 90 wt% of the wholly aromatic polyamide ($PA^{B-3}$). More preferably, $RC^{B-3}$ comprises 40 to 98 wt% of the wholly aromatic polyimide ($PI^{B-3}$) and 2 to 60 wt% of the wholly aromatic polyamide ($PA^{B-3}$).

<wholly aromatic polyimide ($PI^{B-3}$)>

The wholly aromatic polyimide ($PI^{B-3}$) has the same constituent components as the wholly aromatic polyimide ($PI^{A-1}$).

Therefore, the preferred wholly aromatic polyimide ($PI^{B-3}$) is a wholly aromatic polyimide comprising a constituent unit represented by the following formula (I).

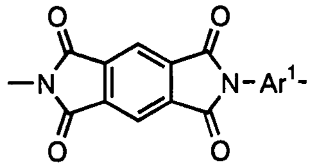

・・・(I)

$Ar^1$ in the above formula (I) is a 1,4-phenylene group which may contain a non-reactive substituent. Examples of the non-reactive substituent include alkyl groups such as methyl group, ethyl group, propyl group and cyclohexyl group, aromatic groups such as phenyl group and naphthyl group, halogen groups such as chloro group, fluoro group and bromo group, alkoxyl groups such as methoxy group, ethoxy group and phenoxy group, and nitro group.

<wholly aromatic polyamide ($PA^{B-3}$)>

The wholly aromatic polyamide ($PA^{B-3}$) has the same constituent components as the wholly aromatic polyamide ($PA^{B-2}$). However, the wholly aromatic polyamide must have a specific glass transition point as described above from the viewpoint of adhesion. A substantially preferred wholly aromatic polyamide differs according to a combination and ratio of constituent components.

A wholly aromatic polyamide represented by the following formula (III) is preferred as the wholly aromatic polyamide ($PA^{B-3}$).

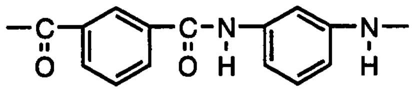

・・・(III)

A wholly aromatic polyamide represented by the following formula (VI) is also preferred.

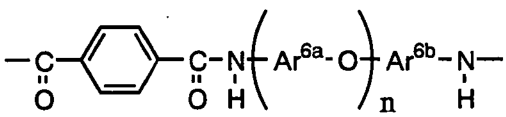

・・・(VI)

In the above formula (VI), $Ar^{6a}$ and $AR^{6b}$ are each independently an aromatic group having 6 to 20 carbon atoms which may contain a non-reactive substituent.

Examples of the aromatic group having 6 to 20 carbon atoms include phenylene group, naphthalenediyl group, anthracenediyl group and toluenediyl group. Phenylene group is preferred, and 1,4-phenylene group and 1,3-phenylene group are particularly preferred.

Examples of the non-reactive substituent include alkyl groups such as methyl group, ethyl group, propyl group and cyclohexyl group, aromatic groups such as phenyl group and naphthyl group, halogen groups such as chloro group, fluoro group and bromo group, alkoxyl groups such as methoxy group, ethoxy group and phenoxy group, and nitro group.

n is 1 or 2. When n is 2, two $Ar^{6a}$'s are substantially existent in the formula (VI) and may be independently different or the same in structure. Particularly preferably, n is 1.

A wholly aromatic polyamide comprising a recurring unit represented by the formula (III) and a recurring unit represented by the formula (VI) may also be used. Preferably, the amount of the recurring unit represented by the formula (III) is 10 to 90 mol% and the amount of the recurring unit represented by the formula (VI) is 90 to 10 mol% of the total of all the recurring units.

<formation of layer B made of resin composition ($RC^{B-3}$)>

The layer B can be formed by casting a solution containing a precursor of the wholly aromatic polyimide ($PI^{B-3}$), the wholly aromatic polyamide ($PA^{B-3}$) and an organic polar solvent over the layer A and drying it. It may be heated to be thermally imidized while it is dried.

The solution can be prepared by polymerizing a polyamic acid or a polyamic acid derivative as a precursor of the wholly aromatic polyimide ($PI^{B-3}$) in an organic polar solvent of the wholly aromatic polyamide ($PA^{B-3}$).

The solution may also be prepared by forming an organic polar solvent solution of a precursor of the wholly

aromatic polyimide ($PI^{B-3}$) and an organic polar solvent solution of a wholly aromatic polyamide and suitably mixing them together or diluting them.

A dehydrating agent such as nitric anhydride or an organic base catalyst such as pyridine may be added as a suitable imidizing aid to the solution.

Casting is carried out by extrusion from a die, with an applicator or with a coater. The temperature of the solution when it is cast is not particularly limited and preferably selected to ensure that the viscosity of the solution becomes 5 to 20,000 poise. The viscosity is more preferably 10 to 10,000 poise.

After casting, the solvent is scattered by drying. Drying is carried out by heating with hot air, vacuum heating, infrared heating or microwave heating. Drying by heating with hot air is preferred. The drying temperature is 30 to 650° C, more preferably 40 to 600° C, much more preferably 70 to 550°C.

As other means, a film made of a resin composition comprising a preproduced wholly aromatic polyimide and a wholly aromatic polyamide is prepared and laminated by a hot roll or a hot press.

The wholly aromatic polyamide ($PA^{B-3}$) can be manufactured by conventionally known solution polymerization or interfacial polymerization. The wholly aromatic polyamide solution after polymerization may be used as it is or after it is isolated and re-dissolved in a solvent. The solvent is preferably an organic polar solvent such as N-methyl-2-pyrrolidone, N,N-dimethylacetamide or N,N-dimethylformamide but a strong acid solvent such as concentrated sulfuric acid, concentrated nitric acid or polyphosphoric acid may be used. An inorganic salt such as calcium chloride, magnesium chloride, lithium chloride or lithium nitrate may be optionally added as a dissolving aid to the above aromatic polyamide solution. The concentration of the polymer in the solution is preferably 1 to 60 wt%, more preferably 3 to 40 wt%.

<laminate (II)>

The present invention includes a laminate (II) which further comprises an adherend layer (C) formed on the layer B of the laminate (I). The layer C may be formed on one side, or independent layers C may be formed on both sides of the laminate. That is, the laminate (II) may comprise layer A/B/C or layers C/B/A/B/C. The layers C on both sides may be the same or different. For example, a laminate which is asymmetrical in the thickness direction, that is, comprises a metal foil as the layer C on one side of the laminate and the wholly aromatic polyimide film as the layer C on the other side may be used.

<adherend layer (C)>

The layer C may be made of an organic or inorganic material. Examples of the organic material include polymer materials such as polyimide, polyester, nylon, polyarylate, polyether imide, wholly aromatic polyamide, epoxy resin, phenolic resin, acrylic resin, polyether ketone, polysulfone, polyphenylene ether, BT resin and polybenzoimidazole.

Examples of the inorganic material include metals such as aluminum, iron, silicon and germanium; alloys such as 42 alloy, iron/nickel alloy, stainless steels and brass; nitride compounds such as barium titanate, potassium titanate, titanium nitride, aluminum nitride and boron nitride; ceramics such as zirconium oxide, aluminum oxide and Cerazin (registered trademark) of Mitsubishi Gas Chemical Co., Ltd.; glass; and carbon.

Semiconductor metals such as silicon and germanium are preferred, and a silicon wafer is more preferred. Therefore, a carbon/epoxy composite manufactured from a prepreg and a porous ceramic/epoxy composite obtained by sintering are such examples.

The difference in linear thermal expansion coefficient between the laminate (I) and the layer C is preferably 30 ppm/°C or less. It is more preferably 25 ppm/°C, particularly preferably 20 ppm/°C or less. Thereby, the laminate can be advantageously used as an insulating material having excellent dimensional stability for electronic material application.

The thickness of the layer C is not particularly limited and differs according to its use and purpose but preferably 1 to 5,000 μm. When the thickness is smaller than 1 μm, the accuracy of a contact bonding device is required for bonding the laminate (I) and it may be difficult to bond the mating surface uniformly. Mechanical strength high enough for contact bonding may not be obtained and the laminate may be broken when it is contact bonded. When the thickness is larger than 5,000 μm, heat for bonding the laminate (I) is hardly conducted and it takes time to transmit a temperature, thereby reducing productivity.

<manufacture of laminate (II)>

Although the method of manufacturing the laminate (II) is not particularly limited, the laminate (I) and the layer C are assembled together at room temperature and optionally under heating and pressure. The assembling method is pressure bonding with a hot press or vacuum press or bonding with a roller.

For example, in the case of pressure bonding with a hot press, a buffer material having a thickness that does not prevent heat conduction may be sandwiched between the roof of the hot press and the laminate (I) and between

the roof and the layer C so as to transmit pressure to the whole mating surface. The buffer material is a protective board, film or fiber. The protective board comprises metal such as stainless steel, iron, titanium, aluminum, copper or alloy thereof. The film and fiber are made of a heat resistant polymer such as a wholly aromatic polyimide or wholly aromatic polyamide.

Preferably, bonding conditions such as temperature, pressure and time are suitably adjusted according to the materials and combination of the laminate (I) and the layer C. The suitable temperature is in the rang of 20 to 600° C. It is more preferably in the range of 50 to 550° C. It is most preferably in the range of 100 to 500 ° C. The pressure is in the range of 0.001 to 1,000 MPa, preferably 0.01 to 100 MPa as an average pressure which is applied to the laminate (I) and the layer C as a whole. When the pressure is lower than 0.001 MPa, the layer C cannot be bonded completely and when the pressure is higher than 1,000 MPa, the layer C may be broken.

The optimum retention time is suitably selected in consideration of the transmission of pressure and heat conductivity which differ by bonding system, bonding temperature and the shape of the layer C. For example, when heat pressure bonding is carried out with a flat hot press, the retention time is preferably 0.1 second to 48 hours. When the retention time is shorter than 0.1 second, adhesive force becomes unsatisfactory and the laminate (II) having stable adhesive force is hardly obtained. When the retention time is longer than 48 hours, productivity deteriorates. In addition, when the laminate is left under high-temperature and high-pressure conditions for a long time and the laminate (II) is bonded to an organic protective layer (D) made of other organic material, adhesive force between the laminate (II) and the organic protective layer (D) may lower. That is, adhesion between the laminate (II) and the organic protective layer (D) on the semiconductor chip lowers. Although the cause of this is not made clear, it is considered that it is caused by the chemical change of the surface in particular of the laminate (II) by heat or a morphology change by high temperature and high pressure. The retention time for bonding is more preferably 1 second to 24 hours. For bonding, after the laminate is bonded at a predetermined pressure by raising the temperature for a predetermined time, it may be left to be gradually cooled to room temperature while it is applied with pressure for a predetermined time, or after the laminate is bonded at a predetermined pressure by raising the temperature for a predetermined time, it may be kept warm while the pressure is released for a predetermined time.

To manufacture the laminate (II) having the layer C on both sides, the layer C may be bonded to both sides at the same time or may be bonded stepwise to one side and then to the other side according to purpose from the viewpoints of cost, bonding accuracy and bonding position accuracy.

<laminate (III)>

The laminate (III) comprises layers A, B and C, an organic protective layer (layer D) and a treated layer (layer E). The layers B and C are formed on one side of the layer A in the mentioned order, and the layers D and E are formed on the other side of the layer A in the mentioned order.

<organic protective layer (D)>

The layer D is an organic film formed on one side of the layer E for the purpose of protecting the layer E. Examples of the resin constituting the layer D include a polyimide, especially a wholly aromatic polyimide, a polyamide, especially an aromatic polyamide, polyether imide, polyamide-imide, polyether ketone, polyether ether ketone, polybenzoimidazole, polyvinyl alcohol, triacetyl cellulose, poly-4-methylpentene, ethylene-vinyl alcohol copolymer, polymethyl methacrylate, tetrafluoroethylene-fluoroalkylvinyl ether copolymer of fluorine (PFA), polyvinylidene fluoride (PVDF), tetrafluroethylene-hexafluoropropylene copolymer (FEP), polychlorotrifluoroethylene (PCTFE) and chlorotrifluoroethylene-ethylene copolymer (E/CTFE).

An example of the layer D is an organic protective film used for the protection and insulation of a semiconductor circuit in the manufacture of a thinned semiconductor. Therefore, conventionally known organic insulating films may be used. Out of these, silicone modified polyimide, polyimide, polybenzoimidazole and polyamide films having high heat resistance can be preferably used.

The thickness of the layer D is preferably 1 nm to 1,000 μm. It is more preferably 10 nm to 500 μm, much more preferably 100 nm to 100 μm.

The layer D may be formed by any conventionally known method such as surface polymerization or sol-gel method as coating techniques. Stated more specifically, the layer D is formed by applying vanish with a spin coater. The film is formed by optically curing the coated vanish if it is a photosensitive resin or thermally curing it if it is a thermosetting resin, or by heating and drying a solvent. In the case of photosensitive vanish, the protective layer can be formed by special and specific patterning through exposure as required.

<layer (E) to be treated >

The layer E is preferably a multi-layer structure comprising multiple layers formed on the side opposite to the exposed surface to be treated. The layer E is an electronic circuit comprising a semiconductor substrate such as a silicon wafer, gallium-arsenide wafer or silicon carbide wafer, or ceramic substrate.
For example, it is a circuit part formed layer formed on a silicon wafer by coating. The sputtering of a metal such as aluminum and circuit formation using the metal may be carried out.
The thickness of the layer E is not particularly limited but preferably 5 to 2,000 μm. It is more preferably 10 to 1,000 μm, particularly preferably 10 to 500 μm.
The layer E may be formed by any conventionally known semiconductor manufacturing method. The method is described in detail in "First Semiconductor Process" (written by Kazuo Maeda, published by Kogyo Chousa-kai) and "All about Semiconductors" (written by Masanori Kikuchi, published by Nippon Jitsugyo Shuppansha), for example.

<process for manufacturing laminate (III)>

The process for manufacturing the laminate (III) is not particularly limited and any conventionally known method may be employed. The above layer C and a laminate comprising the layers E and D are assembled with the laminate (I) under heat and pressure.
A laminate comprising the layer A formed on layer B or a laminate obtained by preparing the layers A and B as films and bonding them together with a hot press may be used as the laminate (I), and the layers A and B may be prepared as films and assembled with the layer C and the laminate comprising the layers E and D.
Further, the laminate (III) may be obtained by suitably assembling together a desired combination of layers in multiple stages. The layers are assembled together by pressure bonding with a hot press or vacuum press or by bonding with a roller. For assembly, the layer A constituting the laminate (I) must be in contact with the layer D and the layer B must be in contact with the layer C. When this order is reversed, sufficiently high adhesive force may not be obtained and releasability after a heat treatment may become unsatisfactory.
For example, in the case of pressure bonding with a hot press, a layer to be brought into contact with the roof of the hot press is set in the hot press. A buffer material having a thickness that does not prevent heat conduction may be interposed between the layer and the roof so as to transmit pressure to the whole mating surface. The buffer material is a protective board made of metal such as stainless steel, iron, titanium, aluminum, copper or alloy thereof; a film made of a heat resistant polymer such as a wholly aromatic polyimide and/or a wholly aromatic polyamide; or a resin such as a fiber of any one of these heat resistant polymers.
When a semiconductor wafer such as a silicon wafer is used, a mold having a shape corresponding to the semiconductor wafer may be used. Although bonding conditions such as temperature, pressure and time are not particularly limited, they can be freely controlled by the materials and combination of the layers C, E and D and the laminate (I).
The preferred temperature for bonding is, for example, 150 to 600° C. It is more preferably 180 to 550° C. It is much more preferably 200 to 500°C.
The pressure for bonding is 0.01 to 500 MPa as average pressure which is applied to the layers C and E as a whole. When the average pressure is lower than 0.01 MPa, the layers C and E cannot be bonded fully and when the pressure is higher than 500 MPa, the layer C or E may be broken. It is preferably 0.1 to 100 MPa.
The retention time for bonding is preferably 0.1 second to 24 hours. When the retention time is shorter than 0.1 second, a laminate having stable adhesive force is hardly obtained due to insufficient adhesive force. When the retention time is longer than 24 hours, productivity lowers and costs rise. The retention time for bonding is more preferably 1 second to 12 hours, much more preferably 1 second to 1 hour, particularly preferably 1 second to 10 minutes.
After they are bonded together at a predetermined pressure by raising the temperature for a predetermined time, the resulting laminate may be left to be gradually cooled to room temperature while it is pressurized for a predetermined time, or after they are bonded together at a predetermined pressure by raising the temperature for a predetermined time, the resulting laminate may be kept warm while the pressure is released for a predetermined time. Or, it may be forcedly cooled by ventilation.

<process for manufacturing laminate (V)>

The present invention includes a process for manufacturing a laminate (V) comprising the layer D and the layer E (layer E') to be treated from the laminate (III). The process comprises the steps of:

(1) surface treatment step: treating the exterior surface of the layer E of the laminate (III) to obtain a laminate (III') comprising a layer E';
(2) heat treatment step: maintaining the laminate (III') at a temperature of at least 350°C;

(3) first disassembling step: removing the layer C from the laminate (III') to obtain a laminate (IV) comprising the layers B, A, D and E'; and

(4) second disassembling step: disassembling the laminat: at the interface between the layers A and D to obtain a laminate (V) comprising the layers D and E'.

In the process of the present invention, it has been found that it is possible to separate the layer C from the layer B easily by controlling a change in peel strength between the layers B and C by a heat treatment. The layer D can be easily and mechanically removed from the layer A by making use of a difference between shear peel strength and peel strength.

The removal of the layer C is preferably carried out by applying ultrasonic waves. More preferably, while the laminate (III') is immersed in water, it is irradiated with ultrasonic waves for 30 seconds or more. The treatment of the exterior surface of the layer E is preferably a thinning treatment. The layer E is preferably a semiconductor substrate having circuit parts formed thereon.

<surface treatment step>

The surface treatment step is the step of obtaining the laminate (III') comprising the treated layer (E') by treating the exposed surface of the layer E of the laminate (III).

The treatment of the exposed surface of the layer E is, for example, a thinning step, such as the grinding of the wafer or polishing after grinding. The treatment may be the surface pre-treatment of the rear surface of the wafer substrate with hydrofluoric acid or nitric acid. Further, the treatment may be a treatment for the formation of a metal thin film on the rear surface of the wafer substrate, including the metal deposition of aluminum or gold and 1 hour or less of baking at about 250 to 500°C. These treatments may be carried out alone or in combination.

Out of these, a thinning treatment by polishing or grinding is particularly preferred. The thickness of the layer E (E') to be treated is preferably 400 μm or less, more preferably 200 μm or less, much more preferably 100 μm or less. The lower limit of the thickness is not particularly limited if the strength of the layer E' is retained but preferably 3 μm or more, more preferably 5 μm or more.

A heat treatment step which will be described hereinafter may be included in this series of treatments. For example, the exposed surface of the layer E may be ground to be made thin and then a heat treatment may be carried out so as to introduce impurities. After an acid treatment is carried out as a surface pre-treatment, a metal is deposited and a circuit is formed from the metal film or by etching the metal film and may be subjected to a heat treatment to be baked. When these heat treatment temperatures are 350° C or higher, they are heat treatment steps.

<heat treatment step>

The heat treatment step is the step of maintaining the laminate (III') at a temperature of 350° C or higher.

Since the laminate (III) of the present invention comprises the laminate (I) comprising the layers A and B as an adhesive sheet, even when it is heated at 350° C or higher, the adhesive force of the adhesive sheet is not increased more than required and suitable adhesion and releasability are maintained. That is, when a conventional adhesive sheet is used, it is difficult to remove the adhesive sheet by a high-temperature heat treatment. However, when the adhesive sheet of the present invention is used, it can be easily removed after a heat treatment at 350°C or higher.

The heat treatment temperature is more preferably 375°C or higher, much more preferably 400°C or higher, particularly preferably 425°C or higher. The upper limit of the heat treatment temperature is not particularly limited but substantially about 700°C. The heat treatment at 350° C or higher may be carried out in air or an inert gas such as nitrogen, preferably in an inert gas. It may be carried out at normal pressure, in vacuum or under reduced pressure, preferably at normal pressure. However, in the initial stage of the treatment, depressurization may be carried out in order to remove water by nitrogen substitution or moisture absorption.

The heat treatment time is preferably 1 second to 48 hours. When the heat treatment time is shorter than 1 second, releasability and adhesion may not become ideal after the heat treatment and when the heat treatment time is longer than 48 hours, releasability and adhesion may not become ideal due to heat deterioration. The heat treatment time is more preferably 10 seconds to 24 hours, particularly preferably 30 seconds to 12 hours.

According to the present invention, even when a heat treatment is carried out at a high temperature of 350°C or higher, there is no phenomenon that adhesion is increased, removal can be easily carried out, and the laminate (V) can be obtained effectively.

<first disassembling step>

This is the step of obtaining the laminate (IV) by removing the layer C from the laminate (III') which has been

subjected to the heat treatment. To obtain the laminate (V), if the interface between the layers A and D is disassembled, the target is achieved. However, as the adhesive force of the interface between the layers A and D is strong, when a stiff layer like the layer C is existent, it is difficult to remove it directly.

Therefore, the interface between the layers B and C is first disassembled. To disassemble the interface between the layers B and C, the following method is employed.

For example, the layers B and C can be separated from each other, making use of volume expansion by immersing the laminate (III') in water at 0 to 100° C for 1 second to 12 hours to absorb water and bringing it into contact with a hot plate heated at 200° C or higher to be heated quickly so as to vaporize water. They can also be separated from each other, making use of volume expansion by immersing the laminate (III') which has absorbed water in liquid nitrogen to be cooled quickly so as to freeze water. Further, they can be separated from each other, making use of a thermal expansion difference by cooling one side of the laminate (III') to 0° C with ice and bringing the other side into contact with a plate heated at 200° C or higher to heat it. And, they are separated from each other by immersing the laminate (III') in a solution to be irradiated with ultrasonic waves. Further, they are separated from each other by immersing the laminate (III') in an alkali solution to dissolve it.

A method of separating layers from each other by applying ultrasonic waves is particularly preferred because it is simple and there is no possibility of contamination or deterioration by chemicals. Stated more specifically, water is preferred as a medium for the application of ultrasonic waves. That is, a method in which the laminate (III') immersed in water is irradiated with ultrasonic waves is preferred, and the irradiation time is preferably 30 seconds or longer. The upper limit of the irradiation time is not particularly limited but substantially 24 hours or less, preferably 5 hours or less, more preferably 2 hours or less, particularly preferably 1 hour or less from the viewpoint of productivity.

The laminate (IV) comprising the layers B, A, D and E' is obtained by disassembling the interface between the layers B and C as described above. The removed layer C is collected and can be recycled for the manufacture of the laminate (II) and/or the laminate (III). To recycle the layer C, the surface of the layer C may be rinsed as required, treated with an alkaline and/or acid solution, or polished with a silicon carbide abrasive.

<second disassembling step>

This is the step of obtaining the laminate (V) by disassembling the interface between the layers A and D of the laminate (IV). That is, it is the step of obtaining the laminate (V) comprising the layers D and E' by removing the laminate (I) comprising the layers B and A from the laminate (IV) comprising the layers B, A, D and E' obtained as described above.

Since the laminate (I) is a flexible laminate, it can be removed in the same manner as when it is removed for the measurement of so-called "peel strength". This is because the laminate (I) has low peel strength while it has high shear peel strength. The removal temperature can be suitably optimized by a combination of components used in the layers and not particularly limited. It is preferably 0 to 300°C, more preferably 0 to 200°C.

According to the method of the present invention, the laminate (V) can be effectively obtained by removing the laminate (I) stepwise. When the laminate (V) becomes very thin like a thinned semiconductor, it may be difficult to handle the laminate (V) due to its warp or deformation. In the disassembling step or the subsequent handling step, an unrequired stress load may be applied to the laminate (V), thereby damaging the laminate (V). In this case, prior to the disassembling step, the exposed surface of the layer E' of the laminate (III') is pre-fixed to a dicing tape affixed to a frame and then the first and second disassembling steps are carried out to obtain the laminate (V) which is put on the dicing tape in the end.

The laminate (V) comprising the layers E' and D is effectively obtained through the above steps. The obtained laminate (V) comprising the layers E' and D is advantageously used as a semiconductor substrate or a thinned semiconductor substrate.

## Examples

The following examples are provided to further illustrate the present invention. The methods of measuring physical properties and the method of evaluating the effect of the present invention were carried out as follows.

### (1) Adhesion

When the laminate (II) is to be manufactured by forming the adherend layer (layer C) on the laminate (I) comprising the layers A and B, adhesion is evaluated based on the following criteria.

* they cannot be bonded together: X
* they can be bonded together but peeling occurs from a bent portion when bent by hand or the laminate (I) can be removed from the laminate (II) by hand almost without force: Δ
* removal is impossible by bending by hand, or difficult at the bonding interface even when tried by hand: ○

(2) measurement of viscoelasticity

A sample measuring 22 mm x 10 mm is used and heated at 50 to 500°C to measure its viscoelasticity with Rheometrics RSA II at a frequency of 6.28 rad/s. Its glass transition point is calculated from a value of dynamic loss tangent tan $\delta$ obtained from the measured dynamic storage elastic modulus E' and dynamic loss elastic modulus E''.

(3) mechanical properties of film

As for the Young's moduli, strength and elongation of the adhesive sheet (laminate (I)) or the base layer (A), a sample measuring 50 mm x 10 mm is used for the measurement of the above values with Orientec UCT-1T at a pulling rate of 5 mm/min at 25°C.

(4) Measurement of surface roughness of silicon wafer

A center portion measuring 1.2 mm x 0.92 mm of a silicon wafer is measured with the NT-2000 non-contact 3-D microsurface configuration observation system (WYKO).

(5) Degree of swelling

The degree of swelling is calculated from the weight of a swollen state ($W_W$) and the weight of a dry state ($W_D$) based on the following equation (1).

$$\text{Degree of swelling (wt/wt\%)} = (W_W/W_D - 1) \times 100 \qquad (1)$$

(6) Linear thermal expansion coefficient

A sample measuring about 13 mm ($L_0$) x 4 mm is used to measure a change $\Delta L$ in its length at a temperature range between 100°C and 200°C by increasing and reducing its temperature between 50° C and 250° C at a temperature elevation rate of 10° C/min with the TMA 2940 Thermomechanical Analyzer of TA Instrument Co., Ltd. to calculate its linear thermal expansion coefficient from the following equation (2).

$$\text{Linear thermal expansion coefficient (ppm/°C)} = 10{,}000 \times \Delta L/L_0 \qquad (2)$$

(7) Measurement of viscosity

The intrinsic viscosity [$\eta$] (dl/g) is calculated from the measurement result obtained by using a 1 wt% lithium chloride/NMP solution as dissolving solution having an aromatic polyamic acid composition content of 0.05 wt% at a temperature of 0°C.

Example 1 (preparation of polyamic acid NMP solution (PAA solution))

1,920 g of dehydrated NMP was fed to a reactor equipped with a thermometer, stirrer and feedstock input port in a nitrogen atmosphere, and 26.52 g of 1, 4-phenylenediamine was further added to and completely dissolved in the dehydrated NMP. Thereafter, the resulting solution was cooled in an ice bath to reduce the temperature of the diamine solution to 3°C. 53.46 g of pyromellitic anhydride was added to the cooled diamine solution to carry out a reaction for 1 hour. The temperature of the reaction solution was 5 to 20° C. The reaction solution was further reacted at room temperature (23°C) for 3 hours, 0.091 g of phthalic anhydride was added to carry out the reaction for 1 hour for the terminal capping of the amine, and a 4 wt% polyamic acid NMP solution (to be referred to as "PAA solution" hereinafter) was obtained as a viscous solution.

(layer A ($PI^{A-1}$))

The obtained PAA solution was cast over a glass sheet with a 1.5 mm-thick doctor blade, the glass sheet was

immersed in a dehydration condensation bath comprising 1,050 ml of acetic anhydride, 450 g of pyridine and 1,500 ml of NMP at 30°C for 30 minutes to be imidized/isoimidized, and the resulting film was separated from the glass sheet as a support to obtain a gel film.

The obtained gel film was immersed in NMP at room temperature for 20 minutes to be rinsed, fixed with a chuck at both ends and stretched to 1.85 times in two crossing directions simultaneously at room temperature at a rate of 10 mm/sec. The degree of swelling of the gel film at the start of stretching was 1,510 %.

The stretched gel film was fixed to a frame and dried and heated with a hot air drier using dry air in multiple stages from 160°C to 300°C. Thereafter, a hot air circulating oven was used to heat the gel film in multiple stages from 300 to 450° C to obtain a wholly aromatic polyimide film (layer A). Therefore, the layer A was made of a wholly aromatic polyimide comprising only a constituent unit represented by the following formula (I-a).

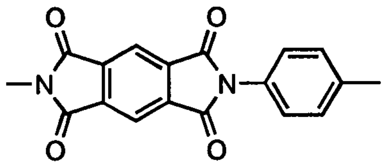

· · · (I-a)

The obtained layer A had a thickness of 13 μm and Young's moduli in the longitudinal direction and the transverse direction of 17.2 GPa and 18.5 GPa, respectively. When the dynamic viscoelasticity of the layer A was measured at 50 to 500°C, no glass transition point was observed. It was confirmed from this that the glass transition point of the layer A was 500°C or higher. The linear thermal expansion coefficient of the layer A was -6 ppm/°C.

(layer B ($PA^{B-2}$))

Powders of the Conex (registered trademark) of Teijin Techno Products Limited were dispersed in N-methyl-2-pyrrolidone (to be abbreviated as NMP hereinafter) at 5° C and dissolved at 40° C to obtain a 10 wt% solution. This 10 wt% solution of the Conex (registered trademark) was cast over the above layer A affixed to the glass sheet with a 28 μm-thick bar coater. Thereafter, the resulting film was dried with a hot air drier at 160°C for 30 minutes and heated in multiple stages to carry out a drying and heat treatment at a rate of 300°C/30 min in the end so as to form an adhesive layer (B) made of a wholly aromatic polyamide on the layer A. Therefore, the layer B was made of a wholly aromatic polyamide represented by the following formula (III).

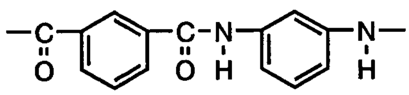

· · · (III)

The laminate (I) comprising the layer A and the layer B formed on one side of the layer A was obtained.

The thickness of the laminate was 16 μm. Therefore, the thickness of the layer B was 3 μm. The glass transition point of the layer B was 285°C. The Young's moduli in the longitudinal direction and the transverse direction of the laminate were 13.9 GPa and 13.6 GPa, respectively. The linear thermal expansion coefficient of the laminate was -5 ppm/°C.

Example 2

(B/A/B)

The laminate (I) obtained in Example 1 was affixed to a glass sheet in such a manner that the layer A faced up to be fixed. A 10 wt% NMP solution of the Conex (registered trademark) was cast over the laminate with a 28 μm-thick bar coater. Thereafter, the resulting film was dried with a hot air drier at 160° C for 30 minutes and heated in multiple stages to carry out a drying and heat treatment at a rate of 300° C/30 min in the end so as to form a layer B made of a wholly aromatic polyamide. A laminate having the layer B on both sides of the layer A was thus obtained.

The thickness of the laminate was 19 μm. That is, the laminate having the layer B having a thickness of 3 μm and made of a wholly aromatic polyamide on both sides of the layer A having a thickness of 13 μm and made of a wholly aromatic polyimide film was obtained. The glass transition point of the layer B was 285°C which is the same as that of Example 1.

The Young's moduli in the longitudinal direction and the transverse direction of the laminate were 11.2 GPa and 10.7 GPa, respectively. The linear thermal expansion coefficient of the laminate was -4 ppm/°C.

Example 3

(layer A ($PA^{A-2}$))

Aramica (registered trademark) which is a wholly aromatic aramide film manufactured by Teijin Advanced Film Co., Ltd. was used as the layer A. Therefore, the layer A was a wholly aromatic polyamide film comprising only a constituent unit represented by the following formula (II).

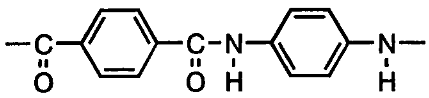

· · · (II)

The layer A had a thickness of 12 μm and Young's moduli in the longitudinal direction and the transverse direction of 14.9 GPa and 14.6 GPa, respectively. It had a glass transition point calculated from the measurement of dynamic viscoelasticity of 355°C. The linear thermal expansion coefficient of the layer A was 2 ppm/°C.

(layer B ($PA^{B-2}$))

Further, a 10 wt% solution of the Conex (registered trademark) was cast over the layer A affixed to a glass sheet to be fixed with a 28 μm-thick bar coater. Thereafter, the resulting film was dried with a hot air drier at 160°C for 30 minutes and heated in multiple stages to carry out a drying and heat treatment at a rate of 300°C/30 min in the end so as to obtain a laminate (I) having a layer B. Therefore, the layer B was made of a wholly aromatic polyamide represented by the following formula (III).

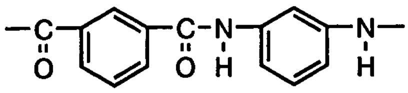

· · · (III)

Thus, a laminate (I) comprising the layer A and the layer B formed on one side of the layer A was obtained.

The thickness of the laminate was 15 μm. Therefore, the thickness of the layer B was 3 μm. The glass transition point of the layer B was 285° C. The Young's moduli in the longitudinal direction and the transverse direction of the laminate were 11.4 GPa and 10.8 GPa, respectively. The linear thermal expansion coefficient of the laminate was 2 ppm/° C.

Example 4

(layer A ($PI^{A-1}$))

The same wholly aromatic polyimide film as that used in Example 1 was used as the layer A.

(layer B ($PI^{B-1}$))

1, 840 g of dehydrated NMP was fed to a reactor equipped with a thermometer, stirrer and feedstock input port in a nitrogen atmosphere, and 76.58 g of 3,4'-diaminodiphenyl ether was further added to and completely dissolved in the dehydrated NMP. Thereafter, the resulting solution was cooled in an ice bath to reduce the temperature of the diamine solution to 3° C. 83.42 g of pyromellitic anhydride was added to the cooled diamine solution to carry out a reaction for 1 hour. The temperature of the reaction solution was 5 to 20° C. The reaction solution was further reacted at 50° C for 3 hours to obtain a 8 wt% NMP solution of a polyamic acid as a viscous solution. This 8 wt% NMP solution of a polyamic acid was cast over the layer A affixed to a glass sheet to be fixed with a 28 μm-thick bar coater. Thereafter, the resulting film was dried with a hot air drier at 160°C for 30 minutes and heated in multiple stages to carry out a drying and thermal imidizing treatment at a rate of 350°C/20 min in the end so as to form a layer B made of a wholly aromatic polyimide on the layer A. Therefore, the layer B was made of a wholly aromatic polyimide represented by the following formula (IV-a).

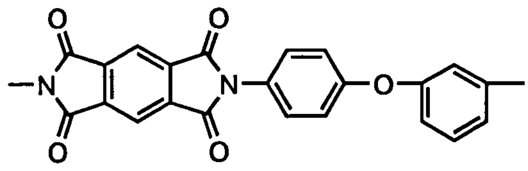

・・・(IV-a)

Thus, a laminate (I) comprising the layer A and the layer B formed on one side of the layer A was obtained.

The thickness of the laminate was 16 μm. Therefore, the thickness of the layer B was 3 μm. The glass transition point of the layer B was 330° C. The Young's moduli in the longitudinal direction and the transverse direction of the laminate were 14.2 GPa and 14.4 GPa, respectively. The linear thermal expansion coefficient of the laminate was -4 ppm/°C.

Examples 5 to 18

(A/B/C)

After the above obtained laminate (I) was placed on the adherend layer (layer C) as shown in Table 1 in such a manner that the layer B came into close contact with the layer C, the both were sandwiched between metal plates, plain weave cloth made of Kevlar was placed on the assembly as a buffer material to eliminate pressure nonuniformity, and the assembly was set in a hot press. After the surface temperature of the actual mating surface was set to 350°C by the hot press, the assembly was pressed at 5.5 MPa for 2 minutes to obtain a laminate (II). The thickness of the laminate (II), adhesion between the layers B and C and the difference (⊿CTE) in linear thermal expansion coefficient between the laminate (I) and the adherend layer (C) are shown in Table 1.

Table 1

| Example | Laminate (I) | Adherend layer (Layer C) | Thickness of adherend layer (Layer C) (μm) | Thickness of laminate (II) (μm) | Adhesion | ⊿CTE (ppm/°C) |
|---|---|---|---|---|---|---|
| 5 | Ex. 1 | Silicon wafer | 625 | 640 | ○ | 9 |
| 6 | Ex. 1 | SUS304 | 1,000 | 1,016 | ○ | 22 |
| 7 | Ex. 1 | Ferrtype plate | 500 | 515 | ○ | not measured |
| 8 | Ex. 1 | Electrolytic copper foil | 35 | 70 | ○ | 23 |
| 9 | Ex. 1 | 42 alloy | 18 | 34 | ○ | 11 |
| 10 | Ex. 1 | Kapton H | 25 | 41 | ○ | 30 |
| 11 | Ex. 3 | Silicon wafer | 625 | 639 | ○ | 2 |
| 12 | Ex. 3 | SUS304 | 1,000 | 1,014 | ○ | 15 |
| 13 | Ex. 3 | Ferro type plate | 500 | 515 | ○ | not measured |
| 14 | Ex. 3 | 42 alloy | 18 | 31 | ○ | 16 |
| 15 | Ex. 3 | Tin plate | 500 | 513 | ○ | not measured |
| 16 | Ex. 4 | Silicon wafer | 625 | 641 | ○ | 8 |
| 17 | Ex. 4 | Copper foil | 35 | 69 | ○ | 22 |
| 18 | Ex. 4 | Kapton H | 25 | 40 | ○ | 29 |
| Ex.: Example | | | | | | |

Example 19

(A/B/A/B/A/B/A/B/A)

After four of the laminates (I) obtained in Example 1 were placed one upon another in such a manner that the four laminates (I) came into close contact with one another and the layer B faced up, the same base material (layer A) as used in Example 1 was further placed on the resulting laminate in such a manner that it came into close contact with the laminate, the resulting assembly was sandwiched between metal plates, plain weave cloth made of Kevlar was placed on the assembly as a buffer material to eliminate pressure nonuniformity, and the obtained assembly was set in a hot press. After the surface temperature of the actual mating surface was set to 350° C by the hot press, the assembly was pressed at 5.5 MPa for 2 minutes to obtain a laminate comprising alternate 5 base layers (A) each composed of a wholly aromatic polyimide film and 4 adhesive layers (B) made of a wholly aromatic polyamide. The thickness of the laminate was 71 μm, and the adhesion of the laminate was evaluated as ○.

Example 20

(A/B/A/B/A/B/A/B/A)

After four of the laminates (I) obtained in Example 3 were placed one upon another in such a manner that the four laminates (I) came into close contact with one another and the layer B faced up, Aramica (registered trademark) which was the same base material (layer A) as used in Example 3 was further placed on the resulting laminate in such a manner that it came into close contact with the laminate, the resulting assembly was sandwiched between metal plates, plain weave cloth made of Kevlar was placed on the assembly as a buffer material to eliminate pressure nonuniformity, and the obtained assembly was set in a hot press. After the surface temperature of the actual mating surface was set to 350° C by the hot press, the assembly was pressed at 5.5 MPa for 2 minutes to obtain a laminate comprising alternate 5 base layers (A) each composed of a wholly aromatic polyamide film and 4 adhesive layers (B) made of a wholly aromatic polyamide. The thickness of the laminate was 69 μm, and the adhesion of the laminate was evaluated as ○.

Example 21

The layer A ($PI^{A-1}$) obtained in Example 1 was used.

(layer B ($PI^{B-3}/PA^{B-3}$ = 47/53))

After powders of the Conex (registered trademark) of Teijin Techno Products Limited were dispersed in NMP at 5° C, they were dissolved at 60°C to obtain a 4 wt% solution. The glass transition temperature of the Conex was 285°C.

Further, the PAA solution, the 4 wt% Conex NMP solution and NMP were mixed together to obtain an NMP solution containing 1.9 wt% of a polyamic acid and 1.9 wt% of a wholly aromatic polyamide.

(A/B)

The NMP solution was cast over the layer A composed of a wholly aromatic polyimide film affixed to a glass sheet with a spiral applicator. Thereafter, the resulting film was dried with a hot air drier at 120°C for 30 minutes and then at 280° C for 20 minutes to carry out a drying and heat treatment at a rate of 350°C/30 min in the end so as to form a layer B. Therefore, the obtained laminate (I) had the layer B made of a resin composition comprising 47 wt% of a wholly aromatic polyimide represented by the above formula (I-a) and 53 wt% of a wholly aromatic polyamide represented by the following formula (III) on one side.

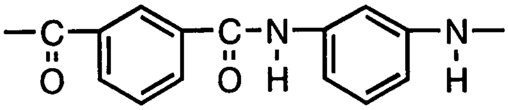

· · · (III)

The average thickness of the laminate was 16 μm. Therefore, the average thickness of the layer B was 3 μm. the Young's moduli in the longitudinal direction and the transverse direction of the laminate were 12.9 GPa and 13.1 GPa, respectively.

Example 22

(B/A/B)

The laminate (I) obtained in Example 21 was affixed to a glass sheet in such a manner that the layer A faced up. The NMP solution containing a polyamic acid and a wholly aromatic polyamide prepared in Example 21 was cast over the laminate with a 28 μm-thick bar coater. Thereafter, the resulting film was dried with a hot air drier at 120°C for 30 minutes and then at 280°C for 20 minutes to carry out a drying and heat treatment at a rate of 300°C/30 min in the end so as to form a layer B made of a resin composition comprising 47 wt% of a wholly aromatic polyimide represented by the above formula (I-a) and 53 wt% of a wholly aromatic polyamide represented by the above formula (III). Thus, the laminate (I) comprising the layer A and the layer B formed on both sides of the layer A was obtained.
The average thickness of the laminate was 19 μm. That is, the laminate comprising the layer A having an average thickness of 13 μm and composed of a wholly aromatic polyimide film and the layer B having an average thickness of 3 μm, made of a resin composition comprising a wholly aromatic polyimide and a wholly aromatic polyamide and formed on both sides of the layer A was obtained. The Young's moduli in the longitudinal direction and the transverse direction of the laminate were 10.8 GPa and 10.6 GPa, respectively.

Example 23

(layer A ($PI^{A-1}$))

(layer B ($PI^{B-3}$/$PA^{B-3}$= 73/27))

A laminate comprising the layer A and the layer B formed on one side of the layer A was obtained in the same manner as in Example 21 except that an NMP solution comprising 2.77 wt% of a polyamic acid and 0.93 wt% of a wholly aromatic polyamide obtained by mixing together a PAA solution, a 4 wt% Conex NMP solution and NMP was used. Thus, the laminate (I) having the layer B made of a resin composition comprising 73 wt% of a wholly aromatic polyimide represented by the above formula (I-a) and 27 wt% of a wholly aromatic polyamide represented by the above formula (III) on one side was obtained.
The average thickness of the laminate was 17 μm. Therefore, the average thickness of the layer B was 4 μm. The Young's moduli in the longitudinal direction and the transverse direction of the laminate were 13.4 GPa and 11.8 GPa, respectively.

Example 24

(layer A ($PI^{A-1}$))

(layer B ($PI^{B-3}$/$PA^{B-3}$=83/17))

The layer B was formed on one side of the layer A in the same manner as in Example 21 except that an NMP solution comprising 2.97 wt% of a polyamic acid and 0.53 wt% of a wholly aromatic polyamide obtained by mixing together a PAA solution, a 4 wt% Conex NMP solution and NMP was used. Thus, a laminate (I) having the layer B made of a resin composition comprising 83 wt% of a wholly aromatic polyimide represented by the above formula (I-a) and 17 wt% of a wholly aromatic polyamide represented by the above formula (III) on one side was obtained.
The average thickness of the laminate was 16 μm. Therefore, the average thickness of the layer B was 3 μm. The Young's moduli in the longitudinal direction and the transverse direction of the laminate were 12.1 GPa and 13.4 GPa, respectively.

Example 25

(layer A ($PI^{A-1}$))

(layer B ($PI^{B-3}$/$PA^{B-3}$=91/9))

The layer B was formed on one side of the layer A in the same manner as in Example 21 except that an NMP solution comprising 3.04 wt% of a polyamic acid and 0.26 wt% of a wholly aromatic polyamide obtained by mixing together a PAA solution, a 4 wt% Conex NMP solution and NMP was used. Thus, a laminate (I) having the layer B made of a resin composition comprising 91 wt% of a wholly aromatic polyimide represented by the above formula (I-a) and 9

wt% of a wholly aromatic polyamide represented by the above formula (III) on one side was obtained.

The average thickness of the laminate was 16 μm. Therefore, the average thickness of the layer B was 3 μm. The Young's moduli in the longitudinal direction and the transverse direction of the laminate were 13.3 GPa and 13.1 GPa, respectively.

Example 26

(layer A ($PI^{A-1}$))

(layer B ($PI^{B-3}$/$PA^{B-3}$=96/4))

The layer B was formed on one side of the layer A in the same manner as in Example 21 except that an NMP solution comprising 2.88 wt% of a polyamic acid and 0.12 wt% of a wholly aromatic polyamide obtained by mixing together a PAA solution, a 4 wt% Conex NMP solution and NMP was used. Thus, a laminate (I) having the layer B made of a resin composition comprising 96 wt% of a wholly aromatic polyimide represented by the above formula (I-a) and 4 wt% of a wholly aromatic polyamide represented by the above formula (III) on one side was obtained.

The average thickness of the laminate was 15 μm. Therefore, the average thickness of the layer B was 2 μm. The Young's moduli in the longitudinal direction and the transverse direction of the laminate were 12.6 GPa and 13.9 GPa, respectively.

Example 27

(layer A ($PA^{A-2}$))

Aramica 090-RP (registered trademark) which is a wholly aromatic aramide film of Teijin Advanced Film Co., Ltd. was used as the layer A. Therefore, the layer A is a wholly aromatic polyamide film comprising only a constituent unit represented by the above formula (II). The average thickness of the layer A was 9 μm. The Young's moduli in the longitudinal direction and the transverse direction of the layer A were 14.9 GPa and 14.6 GPa, respectively. The linear thermal expansion coefficient of the Aramica was 2 ppm/°C and the glass transition point calculated from the measurement of dynamic viscoelasticity was 355°C.

(layer B ($PI^{B-3}$/$PA^{B-3}$=47/53))

An NMP solution comprising 1.9 wt% of a polyamic acid and 1.9 wt% of a wholly aromatic polyamide was obtained by mixing together a PAA solution, a 4 wt% Conex NMP solution and NMP.

(A/B)

The above NMP solution was cast over the layer A which was the above wholly aromatic polyamide film affixed to a glass sheet with a spiral applicator. Thereafter, the resulting film was dried with a hot air drier at 120°C for 30 minutes and then at 280°C for 20 minutes to carry out a drying and heat treatment at a rate of 300°C/30 min in the end so as to form a layer B on the layer A. Thus, a laminate (I) having the layer B made of a resin composition comprising 47 wt% of a wholly aromatic polyimide represented by the above formula (I-a) and 53 wt% of a wholly aromatic polyamide represented by the above formula (III) on one side was obtained.

The average thickness of the laminate was 13 μm. Therefore, the average thickness of the layer B was 4 μm. The Young's moduli in the longitudinal direction and the transverse direction of the laminate were 9.2 GPa and 9.5 GPa, respectively.

Examples 28 to 42

(A/B/C)

After each of the laminates obtained in Examples 21 and 23 to 27 was placed on the adherend layer (C) as shown in Table 2 below in such a manner that the adhesive layer (B) came into close contact with the adherend layer (C), the resulting assembly was sandwiched between metal plates, plain weave cloth made of Kevlar was placed on the assembly as a buffer material to eliminate pressure nonuniformity, and the assembly was set in a hot press. After the surface temperature of the actual mating surface was set to 350°C by the hot press, the assembly was pressed at 2.7 MPa for 2 minutes to obtain a laminate (II). The evaluation results of average thickness and adhesion of the laminate

are shown in Table 2.

The mating surface of the 6-inch monitor wafer (GKO-3516-A) of Shin-Etsu Semiconductor Co., Ltd. which is a silicon wafer was made of a mirror surface as the adherend layer (C) shown in Table 2 below. A 1 mm-thick mirror surface plate was used as SUS304. The 10 μm-thick 42 Invar of The Niraco Corporation was used as 42 alloy and expressed as "42 Invar" in Table 2. GTS-MP having a thickness of 35 μm manufactured by Furukawa Circuit Foil Co. , Ltd. was used as an electrolytic copper foil. A standard ferrtype plate of 0.4 mm stainless hard chrome of ASANUMA & Co., Ltd. was used as a ferro type plate. The Capton 100H of Toray Du Pont Co. , Ltd. was used as an organic polymer film and expressed as "Kapton H" in Table 2.

Example 43

A laminate was obtained by carrying out hot pressing in the same manner as in Example 28 except that the pressure was changed to 0.5 MPa. The evaluation results of average thickness and adhesion of the laminate are shown in Table 2.

Example 44

A laminate was obtained by carrying out hot pressing in the same manner as in Example 28 except that the pressure was changed to 7.0 MPa. The evaluation results of average thickness and adhesion of the laminate are shown in Table 2.

Example 45

(C/B/A/B/C)

The laminate obtained in Example 22 was sandwiched between two silicon wafers in such a manner that the layers B on both sides of the laminate came into close contact with the mirror surfaces of the silicon wafers and assembled with the silicon wafers, and the resulting assembly was further sandwiched between metal plates. Thereafter, plain weave cloth made of Kevlar was placed on the assembly as a buffer material to eliminate pressure nonuniformity at the time of pressing, and the assembly was set in a hot press. After the surface temperature of the actual mating surface was set to 350°C by the hot press, the assembly was pressed at 2.7 MPa for 2 minutes to obtain a laminate. The evaluation results of average thickness and adhesion of the laminate are shown in Table 2.

The 6-inch monitor wafer (GKO-3516-A) of Shin-Etsu Semiconductor Co., Ltd. was used as a silicon wafer of the layer C shown in Table 2 below. The minor surface of the silicon wafer was used for adhesion surface.

Table 2

| Example | Laminate(I) | Adherend layer (layer C) | Thickness of adherend layer (layer C) (μm) | Thickness of laminate (II) (μm) | Adhesion |
|---|---|---|---|---|---|
| 28 | Example 21 | Silicon wafer | 625 | 639 | ○ |
| 29 | Example 21 | SUS304 | 1,000 | 1,014 | ○ |
| 30 | Example 21 | Ferro type plate | 500 | 515 | ○ |
| 31 | Example 21 | Electrolytic copper foil | 35 | 49 | ○ |
| 32 | Example 21 | 42 Invar | 10 | 25 | ○ |
| 33 | Example 21 | Kapton H | 25 | 38 | ○ |
| 34 | Example 23 | Silicon wafer | 625 | 641 | ○ |
| 35 | Example 24 | Silicon wafer | 625 | 641 | ○ |
| 36 | Example 25 | Silicon wafer | 625 | 640 | ○ |
| 37 | Example 26 | Silicon wafer | 625 | 638 | ○ |
| 38 | Example 27 | Silicon wafer | 625 | 636 | ○ |
| 39 | Example 27 | Electrolytic copper foil | 35 | 45 | ○ |

(continued)

| Example | Laminate(I) | Adherend layer (layer C) | Thickness of adherend layer (layer C) (μm) | Thickness of laminate (II) (μm) | Adhesion |
|---|---|---|---|---|---|
| 40 | Example 27 | Ferro type plate | 500 | 512 | ○ |
| 41 | Example 27 | 42 Inver | 10 | 23 | ○ |
| 42 | Example 27 | Capton H | 25 | 38 | ○ |
| 43 | Example 21 | Silicon wafer | 625 | 640 | ○ |
| 44 | Example 21 | Silicon wafer | 625 | 638 | ○ |
| 45 | Example 22 | Silicon wafer (both sides) | 625 | 1,267 | 0 |

Example 46

(A/B/A/B/A/B/A/B/A)

After four of the laminates obtained in Example 21 were placed one upon another in such a manner that the four laminates came into close contact with one another and the layer B faced up, the same layer A as used in Example 21 was further placed on the resulting laminate in such a manner that it came into close contact with the laminate, the resulting assembly was sandwiched between metal plates, plain weave cloth made of Kevlar was placed on the assembly as a buffer material to eliminate pressure nonuniformity, and the assembly was set in a hot press. After the surface temperature of the actual mating surface was set to 350°C by the hot press, the assembly was pressed at 2.7 MPa for 2 minutes to obtain a laminate comprising alternate 5 base layers (A) each composed of a wholly aromatic polyimide film and 4 adhesive layers (B) made of a wholly aromatic polyamide. The average thickness of the laminate was 76 μm, and the adhesion of the laminate was evaluated as ○.

Example 47

(A/B/A/B/A/B/A/B/A)

After four of the laminates obtained in Example 27 were placed one upon another in such a manner that the four laminates came into close contact with one another and the layer B faced up, Aramica 090RP(registered trademark) of Teijin Advanced Film Co., Ltd. which was the same base material (layer A) as used in Example 27 was further placed on the resulting laminate in such a manner that it came into close contact with the laminate, the resulting assembly was sandwiched between metal plates, plain weave cloth made of Kevlar was placed on the assembly as a buffer material to eliminate pressure nonuniformity, and the assembly was set in a hot press. After the surface temperature of the actual mating surface was set to 350° C by the hot press, the assembly was pressed at 2.7 MPa for 2 minutes to obtain a laminate comprising alternate 5 base layers (A) each composed of a wholly aromatic polyamide film and 4 adhesive layers (B) made of a wholly aromatic polyamide. The average thickness of the laminate was 59 μm, and the adhesion of the laminate was evaluated as ○.

Example 48

(E/D/A/B/C)

(adherend layer (C))

A silicon wafer (C) having a thickness of 625 μm and a diameter of 150 mm was prepared as a supporting substrate. (semiconductor substrate (D/E))

A wafer having a polyimide coating layer (D) with an average thickness of 20 μm was prepared by applying a 20 wt% NMP solution (trade name: Rikacoat EN20) of New Japan Chemical Co., Ltd. to the mirror surface of a silicon wafer (E) having a thickness of 625 μm and a diameter of 150 mm as a semiconductor substrate with a spin coater and drying the coating film at 120°C for 30 minutes and at 200°C for 90 minutes.

(adhesive sheet (A/B))

The laminate (A/B) obtained in Example 24 was prepared as an adhesive sheet.

Then, the adherend layer (C), the adhesive sheet (A/B) and the semiconductor substrate (D/E) were assembled together. The layer B was in contact with the mirror surface of the layer C, and the layer D was in contact with the layer A. In this state, the assembly was set in a hot press to be pressed at 2.7 MPa and 300° C for 2 minutes so as to obtain a laminate (III).

(surface treatment step)

The exposed side of the layer E of the semiconductor substrate of this laminate (III) was set in a polishing machine to polish the layer E with abrasive paper having silicon carbide particles by turning a polishing plate at a revolution of 110 rpm under a load of 160 gf/cm$^2$ so as to obtain a laminate (III') having a 130 μm-thick layer E'. Polishing was carried out at abrasive grit sizes of #150, #800 and #2,000 in the mentioned order. The disassembly of the laminate was not observed during polishing.

(heat treatment step)

The obtained laminate (III') was set in a high-speed high-temperature furnace (SBA-2045 of MOTOYAMA Co., Ltd.) to be heated from 300 to 450° C at a rate of 10° C/min and from 450 to 500°C at a rate of 5°C/min in a nitrogen atmosphere at a flow rate of 1.5 1/min and maintained at 450°C for 1 hour, and then left to be cooled to room temperature.

(first disassembling step)

Then, the laminate (III') was immersed in the water of a ultrasonic washer and irradiated with ultrasonic waves at room temperature for 30 minutes. In less than 10 minutes from the start of irradiation, the interface between the mirror surface of the layer C and the layer B was disassembled naturally. Thus, a laminate (IV) comprising the layers B, A, D and E' was obtained. At this point, the deterioration of the separated layer C was not seen and could be recycled after it was rinsed as required.

(second disassembling step)

After water was wiped out, the adhesive sheet (A/B) existent on the surface of the obtained laminate (IV) was removed by stripping to disassemble the interface between the layers A and D. As a result, a laminate (V) comprising the thinned layer E' and the layer D was obtained. The surface of the layer D of the laminate (V) was clean without the residue of the laminate of layer A.

The laminate of the present invention can be advantageously used as an adhesive sheet in the step of thinning a semiconductor substrate in the semiconductor manufacturing process.

Example 49

(A/B/C)

(layer A ($PI^{A-1}$))

The wholly aromatic polyimide film obtained in Example 1 was prepared as the layer A. That is, the layer A is a wholly aromatic polyimide film comprising only a constituent unit represented by the above formula (I-a).

(layer B ($PI^{B-3}/PA^{B-3}$= 50/50))

Thereafter, 1,500 g of dehydrated NMP was fed to a reactor equipped with a thermometer, stirrer and feedstock input port in a nitrogen atmosphere, and NMP was cooled to 3°C in an ice bath. Then, 49.99 g of powders of Conex (registered trademark) which is a wholly aromatic polyamide of Teijin Techno Products Limited previously dried at 120° C for 6 hours was added and gradually heated to 60°C in the end to be dissolved so as to prepare a 3.2 wt% wholly aromatic polyamide NMP solution.

18.62 g (0.1722 mol) of p-phenylenediamine was added to and completely dissolved in the wholly aromatic polyamide NMP solution as a solvent. Thereafter, the resulting solution was cooled in an ice bath to reduce the temperature of the aromatic diamine solution to 3°C. 37.74 g (0.1730 mol) of pyromellitic anhydride was added to this cooled diamine

solution to carry out a reaction for 1 hour. At this point, the temperature of the reaction solution was 5 to 20° C. The reaction of the reaction solution was further carried out at 60°C for 2 hours to obtain a viscous composition solution comprising a polyamic acid and a wholly aromatic polyamide. The composition solution was an NMP solution containing 3.5 wt% of a polyamic acid and 3.1 wt% of a wholly aromatic polyamide. The intrinsic viscosity of the aromatic polyamic acid composition was 11.2 dl/g.

After the obtained resin composition NMP solution was further diluted with NMP to obtain an NMP solution containing 1. 8 wt% of the polyamic acid and 1. 6 wt% of the wholly aromatic polyamide, the diluted NMP solution was cast over the layer A which was the above wholly aromatic polyimide film affixed to a glass sheet with a spiral applicator. Thereafter, the resulting film was dried with a hot air drier at 120° C for 30 minutes and then at 280°C for 20 minutes to carry out a drying and heat treatment at a rate of 350° C/30 min in the end so as to form a layer B. An adhesive sheet having the adhesive layer (B) made of a resin composition comprising 50 wt% of a wholly aromatic polyimide represented by the above formula (1-a) and 50 wt% of a wholly aromatic polyamide represented by the above formula (III) on one side was obtained.

The average thickness of the laminate was 15 μm. Therefore, the average thickness of the layer B was 2 μm. The Young's moduli in the longitudinal direction and the transverse direction of the laminate were 13.4 GPa and 11.3 GPa, respectively. The linear thermal expansion coefficient of the laminate was 1 ppm/°C.

A 625 μm-thick silicon wafer was bonded to the thus obtained laminate in the same manner as in Example 28 except that the above laminate was used. The obtained laminate (II) had a thickness of 638 μm and was not disassembled when it was bent by hand. Therefore, its adhesion was evaluated as ○.

Example 50

(E/D/A/B/C)

(adherend layer (C))

A silicon wafer having a thickness of 625 μm and a diameter of 150 mm was prepared as the adherend layer (C). (semiconductor substrate (D/E))

A wafer having a polyimide film (D) which was formed on the mirror surface of a silicon wafer (E) having a thickness of 625 μm and a diameter of 150 mm by spin coating was prepared as a semiconductor substrate.

(adhesive sheet (A/B))

An aromatic polyimide film (A) having a thickness of 12.5 μm and a glass transition point of 500° C or higher (glass transition point was not observed up to 500° C by measurement) obtained by cyclodehydrating a condensate synthesized from pyromellitic anhydride and p-phenylenediamine was prepared as an adhesive sheet, and a 15 % N-methyl-2-pyrrolidone solution of an aromatic polyamide (registered trademark Conex of Teijin Techno Products Co., Ltd.) synthesized from isophthalic acid chloride and m-phenylenediamine was coated on one side of the film and dried to form a 3 μm-thick layer B.

The adherend layer (C), the adhesive sheet (A/B) and the semiconductor substrate (D/E) were assembled together. The layer B was in contact with the layer C, and the layer D was in contact with the layer A. In this state, the assembly was set in a hot press and pressed at 5 MPa and 300°C for 2 minutes to obtain a laminate (III).

(surface treatment step)

The exposed side of the layer E of this laminate (III) was set in a polishing machine to polish the layer E with abrasive paper having silicon carbide particles by turning a polishing plate at a revolution of 110 rpm under a load of 160 gf/cm$^2$ so as to obtain a laminate (III') having a 130 μm-thick layer E'. Polishing was carried out at abrasive grit sizes of #150, #800 and #2000 in the mentioned order. The disassembly of the laminate was not seen during polishing.

(heat treatment step)

The obtained laminate (III') was set in a high-speed high-temperature furnace (SBA-2045 of MOTOYAM Co., Ltd.) to be heated from 300 to 450° C at a rate of 10°C/min and from 450 to 500°C at a rate of 5°C/min in a nitrogen atmosphere at a flow rate of 1.5 l/min and maintained at 500°C for 1 hour, and left to be cooled to room temperature.

(first disassembling step)

The laminate (III') was then immersed in the water of a ultrasonic washer to be irradiated with ultraviolet waves at room temperature for 30 minutes. In less than 10 minutes from the start of irradiation, the interface between the layers C and B was disassembled naturally. Thus, a laminate (IV) comprising layers B, A, D and E' was obtained. The deterioration of the separated layer C was not seen and could be recycled after it was rinsed as required.

(second disassembling step)

After water was wiped out, the adhesive sheet existent on the surface of the obtained laminate (IV) was removed by stripping to obtain a laminate (V) comprising the layers D and E'. The surface of the layer D of the laminate (V) was very clean without the residue of the layer A.

Example 51

(adherend layer (C))

A silicon wafer having a thickness of 625 μm and a diameter of 150 mm was prepared as the adherend layer (C). (semiconductor substrate (D/E))

A wafer having a polyimide film (D) which was formed on the mirror surface of a silicon wafer (E) having a thickness of 625 μm and a diameter of 150 mm by spin coating was prepared as a semiconductor substrate.

(adhesive sheet (A/B))

An aromatic polyimide film (layer A: thickness of 12.5μ m) having a glass transition point of 500° C or higher (glass transition point was not observed up to 500° C by measurement) obtained by cyclodehydrating a condensate synthesized from pyromellitic anhydride and p-phenylenediamine was prepared. A 15 % N-methyl-2-pyrrolidone solution of an aromatic polyamide (registered trademark Conex of Teijin Techno Products Limited) synthesized from isophthalic acid chloride and m-phenylenediamine was coated on one side of the film and dried to form a 3 μm-thick layer B so as to obtain an adhesive sheet (A/B).

The adherend layer (C), the adhesive sheet (A/B) and the semiconductor substrate (D/E) were assembled together. The layer B was in contact with the layer C, and the layer D was in contact with the layer A. In this state, the laminate was set in a hot press and pressed at 2 MPa and 300°C for 2 minutes to obtain a laminate (III).

(surface treatment step)

The exposed side of the layer E of this laminate (III) was set in a polishing machine to polish the layer E with abrasive paper having silicon carbide particles by turning a polishing plate at a revolution of 110 rpm under a load of 160 gf/cm$^2$ so as to obtain a laminate (III') having a 130 μm-thick layer E'. Polishing was carried out at abrasive grit sizes of #150, #800 and #2000 in the mentioned order. The disassembly of the laminate was not observed during polishing.

(heat treatment step)

The obtained laminate (III') was set in a high-speed high-temperature furnace (SBA-2045 of MOTOYAM Co., Ltd.) to be heated from 300 to 400° C at a rate of 10° C/min and from 400 to 450°C at a rate of 5°C/min in a nitrogen atmosphere at a flow rate of 1.5 1/min and maintained at 450°C for 1 hour, and left to be cooled to room temperature.

(first disassembling step)

The laminate (III') was then immersed in the water of a ultrasonic washer and irradiated with ultrasonic waves at room temperature for 30 minutes. In less than 10 minutes from the start of irradiation, the interface between the adherend layer (C) and the layer B was disassembled naturally. Thus, a laminate (IV) comprising the layers B, A, D and E' was obtained. At this point, the deterioration of the separated layer C was not seen and could be recycled after it was rinsed as required.

(second disassembling step)

After water was wiped out, the adhesive sheet existent on the surface of the obtained laminate (VI) was removed

by stripping to obtain a laminate (V) comprising the layers D and E'. The surface of the layer D of the laminate (V) was clean without the residue of the layer A.

Industrial Applicability

The laminate of the present invention can be advantageously used as an adhesive sheet in various fields such as electronic materials including package materials, members for use in the semiconductor device manufacturing process, battery containers, aviation parts, auto parts and foods. The process of the present invention is useful for the manufacture of thinned semiconductor parts.

## Claims

1. A laminate (I) comprising a base layer (A) and an adhesive layer (B) formed on one side or both sides of the layer A, wherein
the layer A is a film made of (A-1) a wholly aromatic polyimide ($PI^{A-1}$) having a glass transition point of 350° C or higher or (A-2) a wholly aromatic polyamide ($PA^{A-2}$) having a glass transition point of 350°C or higher; and
the layer B comprises (B-1) a wholly aromatic polyimide ($PI^{B-1}$) having a glass transition point of 180°C or higher and lower than 350°C, (B-2) a wholly aromatic polyamide ($PA^{B-2}$) having a glass transition point of 180°C or higher and lower than 350°C, or (B-3) a resin composition ($RC^{B-3}$) comprising a wholly aromatic polyimide ($PI^{B-3}$) and a wholly aromatic polyamide ($PA^{B-3}$) having a glass transition point of 180°C or higher and lower than 350°C.

2. The laminate according to claim 1 which has two right-angled directions with a Young's modulus of more than 3 GPa in the plane.

3. The laminate according to claim 1, wherein the layer A is a film which has two right-angled directions with a Young's modulus of more than 10 GPa in the plane.

4. The laminate according to claim 1, wherein the layer A is a film which has a linear thermal expansion coefficient of -12 ppm/° C to 12 ppm/° C.

5. The laminate according to claim 1, wherein the average thickness of the layer A is 50 μm or less.

6. The laminate according to claim 1, wherein the wholly aromatic polyimide ($PI^{A-1}$) having a glass transition point of 350° C or higher (A-1) of the layer A comprises a constituent unit represented by the following formula (I):

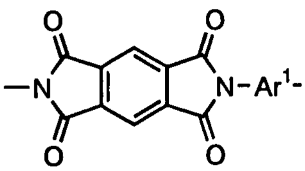
(I)

wherein $Ar^1$ is a 1,4-phenylene group which may contain a non-reactive substituent.

7. The laminate according to claim 1, wherein the wholly aromatic polyamide ($PA^{A-2}$) having a glass transition point of 350° C or higher (A-2) of the layer A comprises a constituent unit represented by the following formula (II):

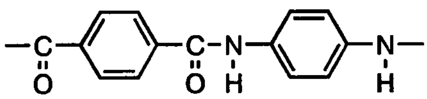
(II)

8. The laminate according to claim 1, wherein the wholly aromatic polyimide ($PI^{B-1}$) having a glass transition point of 180°C or higher and lower than 350°C (B-1) of the layer B comprises a constituent unit represented by the following formula (IV):

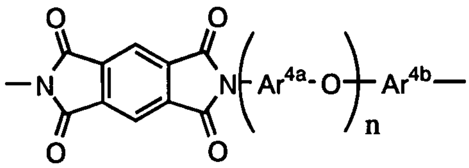

(IV)

wherein $Ar^{4a}$ and $Ar^{4b}$ are each independently an aromatic group having 6 to 20 carbon atoms which may contain a non-reactive substituent, and n is 1 or 2.

**9.** The laminate according to claim 1, wherein the wholly aromatic polyamide ($PA^{B-2}$) having a glass transition point of 180°C or higher and lower than 350°C (B-2) of the layer B comprises a constituent unit represented by the following formula (III):

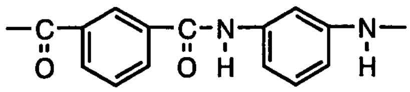

(III)

**10.** The laminate according to claim 1, wherein the resin composition ($RC^{B-3}$) comprises 10 to 99 wt% of the wholly aromatic polyimide ($PI^{B-3}$) and 1 to 90 wt% of the wholly aromatic polyamide ($PA^{B-3}$) having a glass transition point of 180°C or higher and lower than 350°C.

**11.** The laminate according to claim 10, wherein the wholly aromatic polyimide ($PI^{B-3}$) constituting the resin composition ($RC^{B-3}$) comprises a constituent unit represented by the following formula (I):

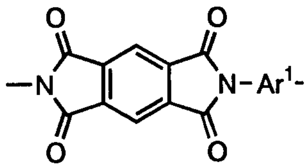

(I)

wherein $Ar^1$ is a 1,4-phenylene group which may contain a non-reactive substituent.

**12.** The laminate according to claim 10, wherein the wholly aromatic polyamide ($PA^{B-3}$) constituting the resin composition ($RC^{B-3}$) comprises a constituent unit represented by the following formula (III):

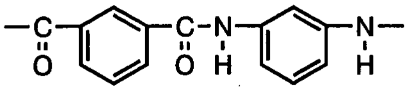

(III)

**13.** The laminate according to claim 1, wherein the layer A comprises $PI^{A-1}$ and the layer B comprises $PI^{B-1}$.

**14.** The laminate according to claim 1, wherein the layer A comprises $pI^{A-1}$ and the layer B comprises $PA^{B-2}$.

**15.** The laminate according to claim 1, wherein the layer A comprises $PI^{A-1}$ and the layer B comprises the resin composition ($RC^{B-3}$) comprising $PI^{B-3}$ and $PA^{B-3}$.

**16.** The laminate according to claim 1, wherein the layer A comprises $PA^{A-2}$ and the layer B comprises $PI^{B-1}$.

**17.** The laminate according to claim 1, wherein the layer A comprises $PA^{A-2}$ and the layer B comprises $PA^{B-2}$.

**18.** The laminate according to claim 1, wherein the layer A comprises $PA^{A-2}$ and the layer B comprises the resin composition ($RC^{B-3}$) comprising $PI^{B-3}$ and $PA^{B-3}$.

**19.** A laminate (II) of claim 1 wherein the layer B is formed on one side of the layer A, and an adherend layer (C) is formed on the layer B.

**20.** The laminate according to claim 19, wherein the layer C comprises an inorganic material.

**21.** The laminate according to claim 19, wherein the layer C comprises a silicon wafer or a metal.

**22.** A laminate (III) of claim 1 comprising a base layer (A), an adhesive layer (B), an adherend layer (C), an organic protective layer (D) and layer (E) to be treated, wherein
the layers B and C are formed on one side of the layer A in the mentioned order, and the layers D and E are formed on the other side of the layer A in the mentioned order.

**23.** The laminate according to claim 22, wherein the layer D comprises a polyimide.

**24.** The laminate according to claim 22, wherein the layer E comprises a silicon wafer.

**25.** A process for manufacturing a laminate (V) comprising a layer D and layer E (E') to be treated from the laminate (III) of claim 22, comprising the steps of:

(1) treating the exterior surface of the layer E of the laminate (III) to obtain a laminate (III') comprising a layer E';
(2) maintaining the laminate (III') at a temperature of 350°C or higher;
(3) removing the layer C from the laminate (III') to obtain a laminate (IV) comprising layers B, A, D and E'; and
(4) disassembling the laminate (IV) at the interface between the layer A and the layer D to obtain a laminate (V) comprising the layers D and E'.

**26.** The manufacturing process according to claim 25,
wherein the layer C is removed by irradiating ultrasonic waves.

**27.** The manufacturing process according to claim 25,
wherein the laminate (III') immersed in water is irradiated with ultrasonic waves for 30 seconds or longer to remove the layer C.

**28.** The manufacturing process according to claim 25,
wherein the treatment of the exterior surface of the layer E is to reduce the thickness of the layer E.

**29.** The manufacturing process according to claim 25,
wherein the layer E is a semiconductor substrate having circuit parts formed thereon.

## INTERNATIONAL SEARCH REPORT

International application No.
PCT/JP2004/019688

A. CLASSIFICATION OF SUBJECT MATTER
Int.Cl$^7$ B32B27/34, C09J7/02, H01L21/304

According to International Patent Classification (IPC) or to both national classification and IPC

B. FIELDS SEARCHED

Minimum documentation searched (classification system followed by classification symbols)
Int.Cl$^7$ B32B27/34, C09J7/02, H01L21/304

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2-272077 A (Nitto Denko Corp.), 06 November, 1990 (06.11.90), Claims; page 3, upper right column to page 4, upper left column; page 5, upper left column to lower left column (Family: none) | 1-6,8,13, 19-21<br>2-4,22-29 |
| X<br>Y | JP 5-105850 A (Sumitomo Bakelite Co., Ltd.), 27 April, 1993 (27.04.93), Claims; Industrial Field of Invention; Par. Nos. [0014] to [0015]; table 1 (Family: none) | 1-4,19-21<br>5-18,22-29 |

[X] Further documents are listed in the continuation of Box C.　　[ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>08 April, 2005 (08.04.05) | Date of mailing of the international search report<br>26 April, 2005 (26.04.05) |
| Name and mailing address of the ISA/<br>Japanese Patent Office<br>Facsimile No. | Authorized officer<br><br>Telephone No. |

Form PCT/ISA/210 (second sheet) (January 2004)

**INTERNATIONAL SEARCH REPORT**

International application No.
PCT/JP2004/019688

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2003-37155 A (Mitsubishi Gas Chemical Co., Inc.), 07 February, 2003 (07.02.03), Claim 1; Par. Nos. [0007], [0016], [0019], [0050] & US 2002/0127821 A1 | 25-29 |
| Y | Edited by The Society of Polymer Science, Japan, Kobunshi ABC Kenkyukai, Polymer ABC Handbook, Kabushiki Kaisha NTS, 01 January, 2001 (01.01.01), pages 72 to 79 | 6-18 |
| Y | JP 10-67851 A (Ube Industries, Ltd.), 10 March, 1998 (10.03.98), Claim 1; table 1 (Family: none) | 1 |
| Y | JP 2003-192788 A (Mitsui Chemicals, Inc.), 09 July, 2003 (09.07.03), Claim 1; table 1 (Family: none) | 1 |
| Y | JP 2000-159887 A (Kaneka Corp.), 13 June, 2000 (13.06.00), Claim 1; table 1 (Family: none) | 1 |
| Y | JP 2-142827 A (Mitsui Toatsu Chemicals, Inc.), 31 May, 1990 (31.05.90), Page 1, lower right column, lines 10 to 15 (Family: none) | 1,7,16,17 |
| Y | JP 61-9458 A (Mitsui Toatsu Chemicals, Inc.), 17 January, 1986 (17.01.86), Page 2, upper right column, line 20 to lower left column, line 17 (Family: none) | 1,9,14,17 |
| A | JP 10-1643 A (Sumitomo Bakelite Co., Ltd.), 06 January, 1998 (06.01.98), Claim 1; Par. Nos. [0022], [0023] (Family: none) | 1-24 |
| A | JP 8-143827 A (Ube Industries, Ltd.), 04 June, 1996 (04.06.96), Claim 1; Par. No. [0027] (Family: none) | 1-24 |
| A | JP 2001-77304 A (Mitsubishi Gas Chemical Co., Inc.), 23 March, 2001 (23.03.01), Par. No. [0005] & US 6337288 B1 | 25-29 |

Form PCT/ISA/210 (continuation of second sheet) (January 2004)

**INTERNATIONAL SEARCH REPORT**

International application No.
PCT/JP2004/019688

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

The invention of claims 1-24 relates to a multilayer body including a multilayer body (I) defined in claim 1 wherein an adhesive layer (B) is formed on either or both sides of a base layer (A).

The invention of claims 25-29 relates to a method for producing a multilayer body including a process wherein the outer surface of a layer (E) of a multilayer body (III), which is composed of a layer (C) to be bonded, an adhesive layer (B), a base layer (A), an organic protective layer (D) and the layer (E) of a material to be processed, is treated into a layer (E'), the resulting is subjected to a heat treatment and then a multilayer body composed of the layers (D) and (E') is obtained by separating (continued to extra sheet)

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest.

☒ No protest accompanied the payment of additional search fees.

**INTERNATIONAL SEARCH REPORT**

International application No.
PCT/JP2004/019688

Continuation of Box No.III of continuation of first sheet(2)

a multilayer body (I) composed of the layers (C), (A) and (B).

Form PCT/ISA/210 (extra sheet) (January 2004)